# EUROPEAN PATENT APPLICATION

(11) **EP 4 492 303 A1**
(43) Date of publication of application: **15.01.2025**
(21) Application number: 23766931.2
(22) Date of filing: 09.03.2023
(51) Int. Cl.: G06N 20/00

(54) **INFORMATION PROCESSING DEVICE, INFORMATION PROCESSING METHOD, RECORDING MEDIUM, AND INFORMATION PROCESSING SYSTEM**

(30) Priority: 09.03.2022 US 202263318070 P
(71) Applicant: Sony Semiconductor Solutions Corporation, Atsugi-shi, Kanagawa 243-0014 (JP)
(72) Inventor: ABE, Hiroshi, Atsugi-shi, Kanagawa 243-0014 (JP); KUNIYOSHI, Jumpei, Atsugi-shi, Kanagawa 243-0014 (JP); NOMURA, Yoshikuni, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/009096
(87) International publication number: WO 2023/171755

(57) **Abstract**

It is attempted to reduce costs and time required for deriving optimum designs of a sensing device and a sensing data analysis process.

An information processing device according to the present technology includes an optimization processing section that updates and optimizes a set parameter of a sensing device simulator which estimates, on the basis of the parameter, sensing data obtained by a sensing device and that updates and optimizes a set parameter of an analysis process executing section which performs, on the basis of the parameter, an analysis process on the sensing data, on the basis of evaluation results of the analysis process performed by the analysis process executing section using, as an input, the sensing data estimated by the sensing device simulator.

## Description

### [Technical Field]

The present technology relates to an information processing device, an information processing method, a recording medium, and an information processing system, and relates to a technology for deriving optimum designs of a sensing device and a sensing data analysis process.

### [Background Art]

For example, various types of sensing devices such as various types of cameras, acceleration sensors, angular velocity sensors, or temperature sensors have been widely used, and various types of applications that perform an analysis process on sensing data obtained by sensing devices have also been widely used. For example, representative examples include an application that performs an image analysis process such as an image recognition process of recognizing the type of a subject and recognizing the face of a subject in an image captured by a camera.

Here, in a case where it is supposed that an application that performs image analysis on images captured by cameras as described above is to be developed, it is not always the case that the cameras are optimized for the image analysis, since the cameras are typically designed to capture images to be seen by humans. In such a manner, for example, it is not necessarily the case that the designs of sensing devices are optimum for an analysis process to be performed by an application.

In view of this, it is desirable that the design of a sensing device can be optimized for an application; however, in the current situation, this undesirably requires a test loop in which giving analysis process results of an application as feedback to sensing device designing to manufacture a new sensing device and evaluating an analysis process on sensing data acquired with the manufactured sensing device and analysis process results thereof are repeated.

Note that examples of related conventional technologies include PTL 1 and NPL 2 described below.

PTL 1 described below discloses a technology of generating training data such that errors between training data and teacher values vary, in order to efficiently produce a highly robust neural network by training.

In addition, NPL 1 described below discloses a technology that uses a simulator of a camera device to optimize, using image quality as an evaluation index, parameters to be used until an image is output from an optical system.

### [Citation List]

### [Patent Literature]

[PTL 1]
PCT Patent Publication No. WO2020/100922

### [Non Patent Literature]

[NPL 1]
VINCENT SITZMANN, et al. "End-to-end Optimization of Optics and Image Processing for Achromatic Extended Depth of Field and Super-resolution Imaging" ACM Trans. Graph., 2018. URL: "https://drive.google.com/file/d/19jSB7d52fyXcFbzGo63Z6zzj70hs5s2Q/vie w"

### [Summary]

### [Technical Problem]

The present technology has been made in view of the circumstances described above, and an object thereof is to attempt to reduce costs and time required for deriving optimum designs of a sensing device and a sensing data analysis process.

### [Solution to Problem]

An information processing device according to the present technology includes an optimization processing section that updates and optimizes a set parameter of a sensing device simulator which estimates, on the basis of the parameter, sensing data obtained by a sensing device and that updates and optimizes a set parameter of an analysis process executing section which performs, on the basis of the parameter, an analysis process on the sensing data, on the basis of an evaluation result of the analysis process performed by the analysis process executing section using, as an input, the sensing data estimated by the sensing device simulator.

By adopting an approach using the sensing device simulator as described above, in optimizing the designs of the sensing device and the analysis process, time and effort for manufacturing a sensor device in each occasion as in conventional techniques can be removed.

In addition, an information processing system according to the present technology includes an analysis process executing section that performs an analysis process on sensing data obtained by a sensing device, on the basis of a set parameter, a sensing device simulator that estimates the sensing data on the basis of a set parameter, and an optimization processing section that updates and optimizes the parameter of the sensing device simulator and the parameter of the analysis process executing section on the basis of an evaluation result of the analysis process performed by the analysis process executing section using, as an input, the sensing data estimated by the sensing device simulator.

Also with such an information processing system, effects similar to those achieved with the information processing device according to the present technology described above can be achieved.

### [Brief Description of Drawings]

[FIG. 1]

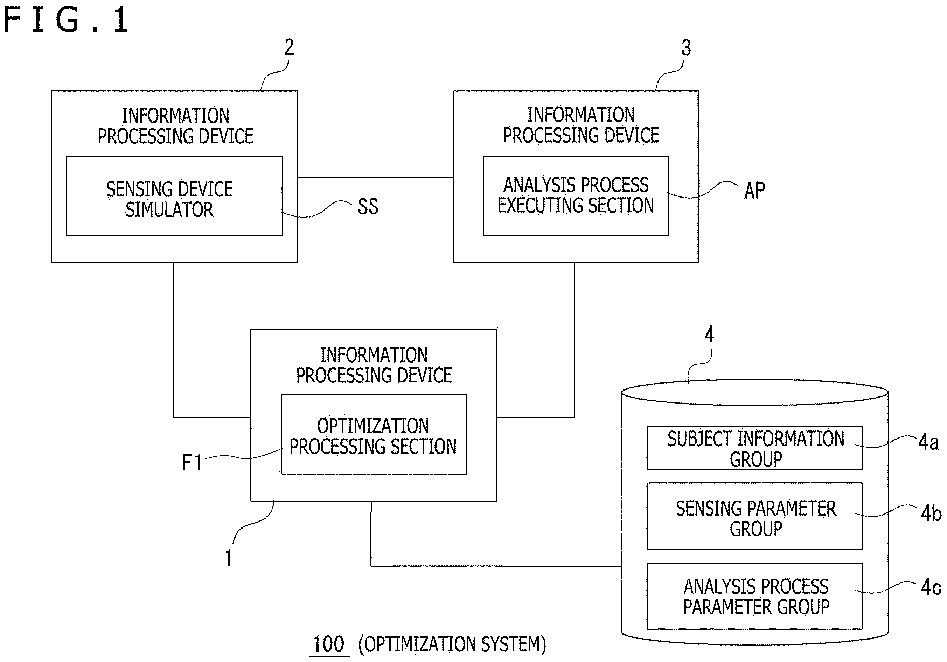

   FIG. 1 is a block diagram depicting a schematic configuration example of an information processing system as a first embodiment according to the present technology.
[FIG. 2]

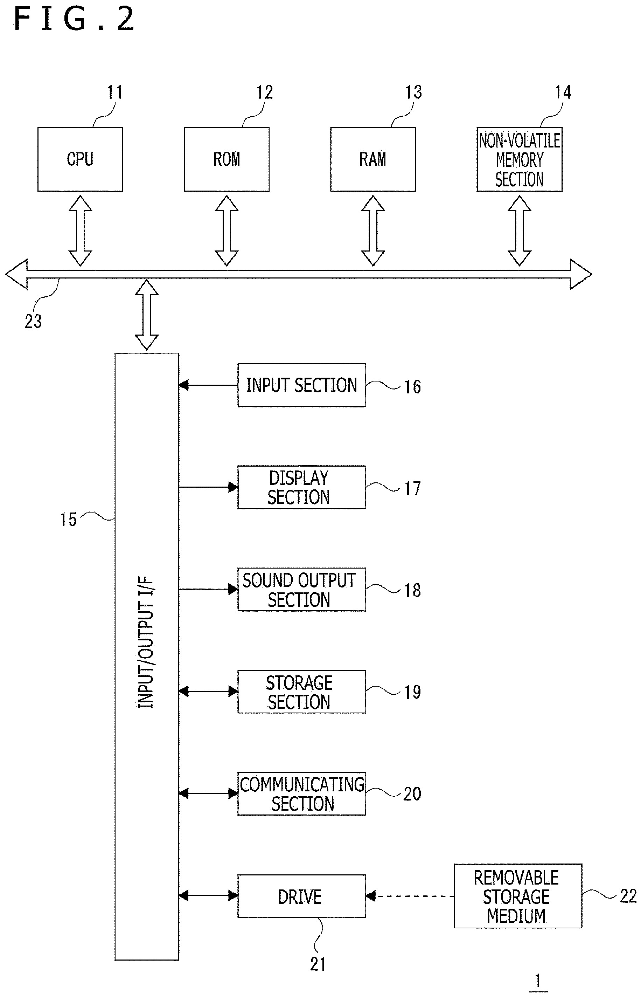

   FIG. 2 is a block diagram depicting a hardware configuration example of an information processing device as the embodiment.
[FIG. 3]

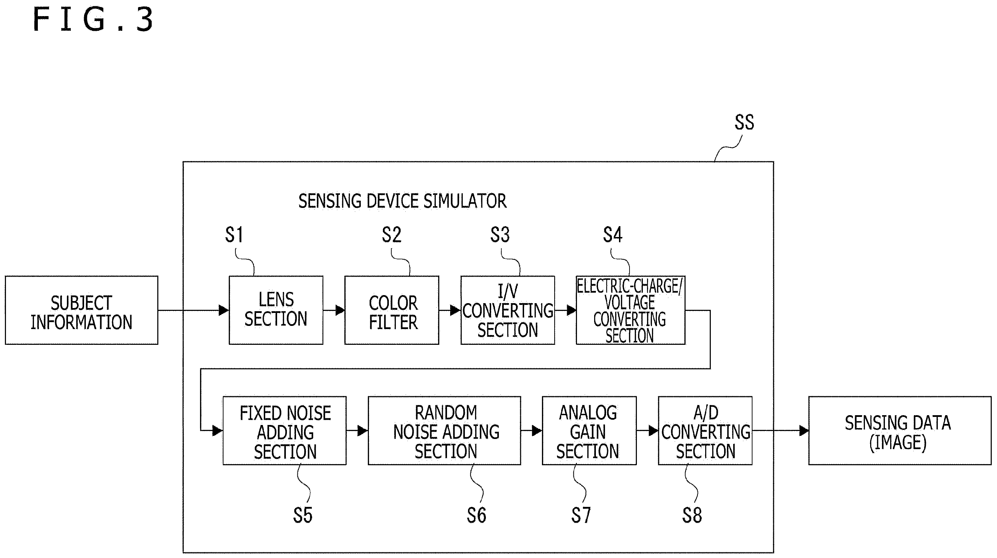

   FIG. 3 is a figure depicting a configuration example of a sensing device simulator as the embodiment.
[FIG. 4]

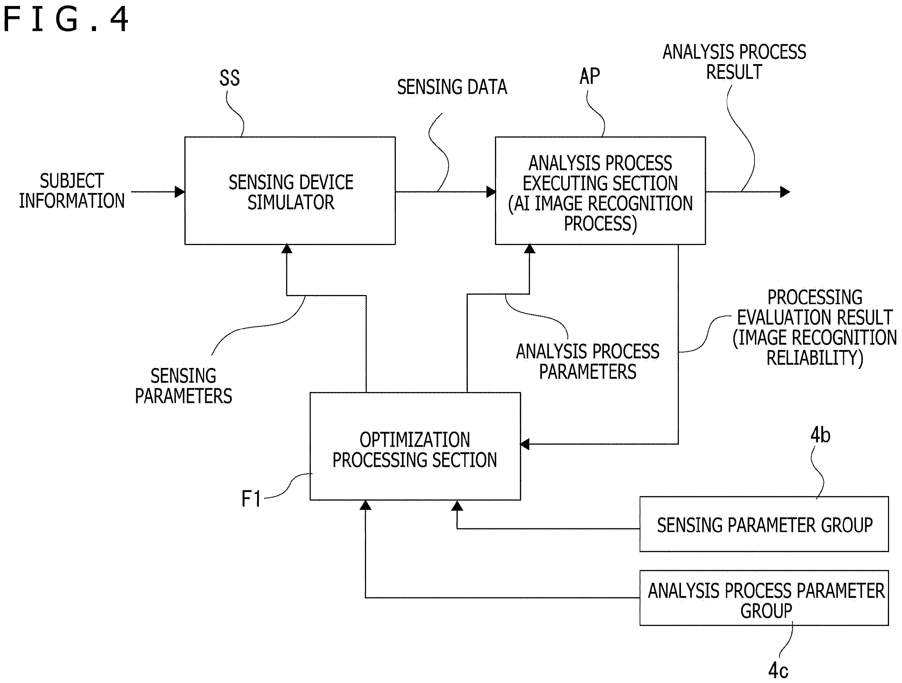

   FIG. 4 is a figure for explaining a parameter optimization approach as the first embodiment.
[FIG. 5]

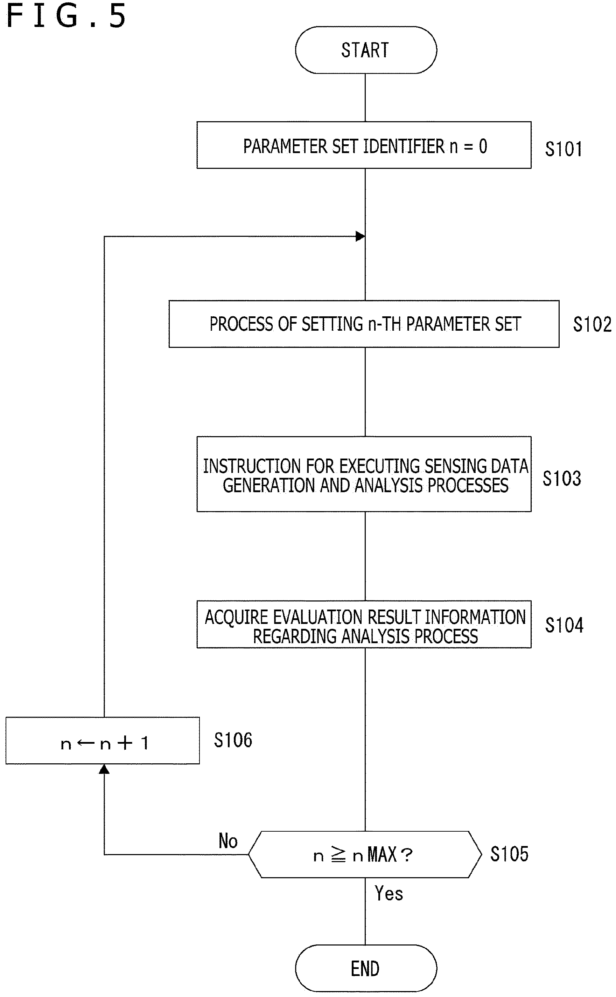

   FIG. 5 is a flowchart depicting a processing procedure example for acquiring evaluation result information regarding an analysis process for each parameter set.
[FIG. 6]

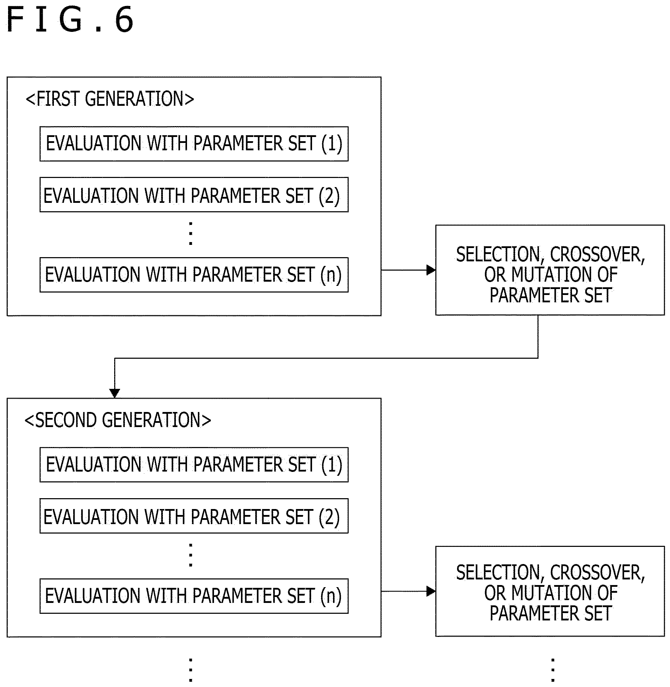

   FIG. 6 is a figure for explaining an approach to optimizing sensing parameters and analysis process parameters with use of a genetic algorithm.
[FIG. 7]

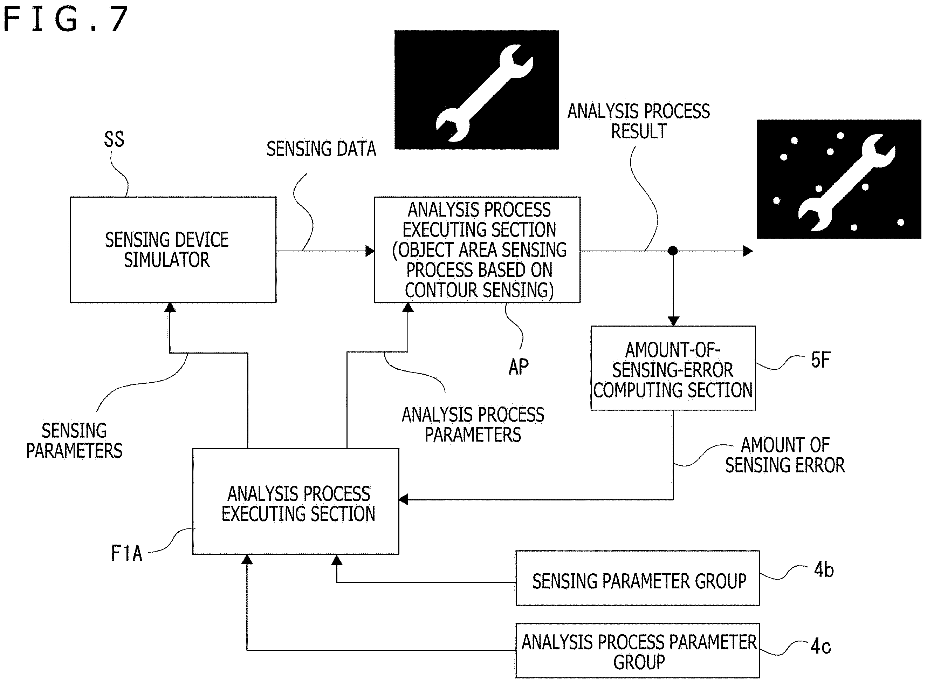

   FIG. 7 is an explanatory diagram of a parameter optimization approach as another example of the first embodiment.
[FIG. 8]

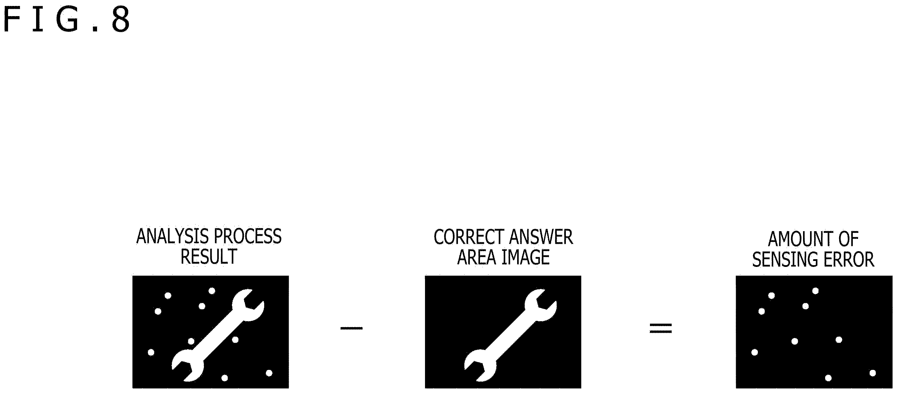

   FIG. 8 is a figure for explaining an example of an amount-of-sensing-error computation approach.
[FIG. 9]

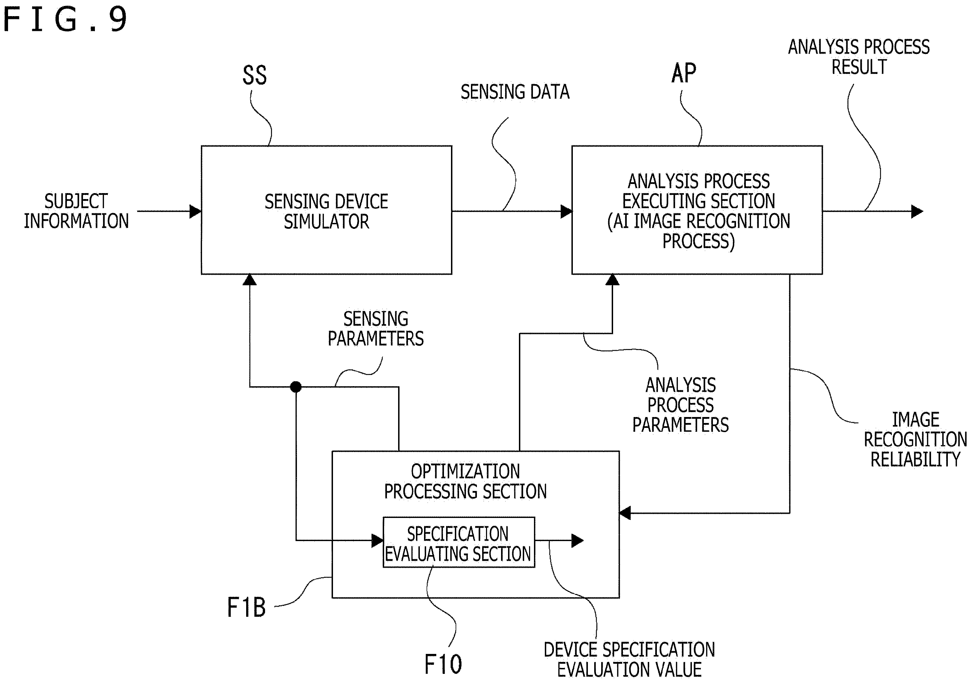

   FIG. 9 is a figure for explaining a parameter optimization approach as a second embodiment.
[FIG. 10]

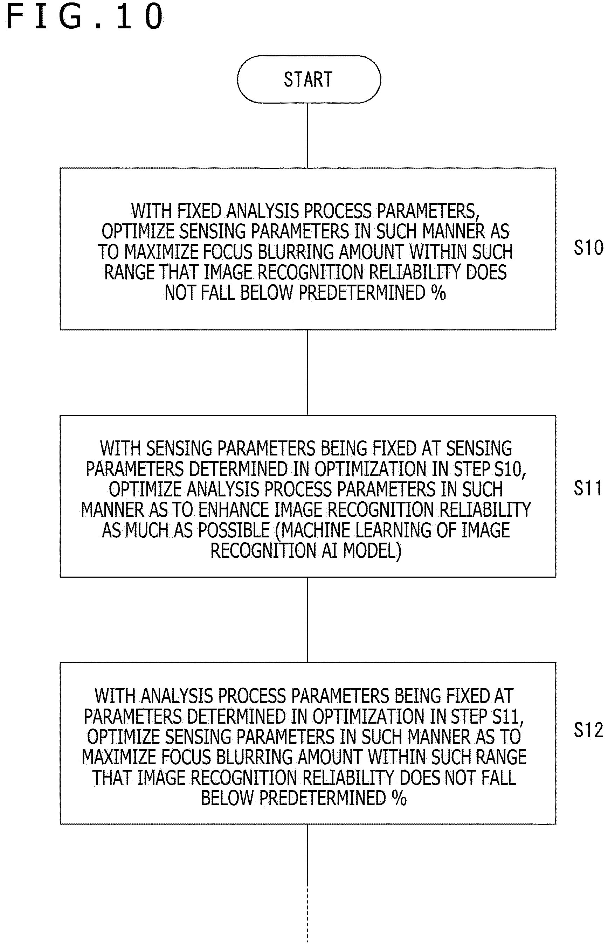

   FIG. 10 is a flowchart depicting a processing procedure example in a case where sensing parameter optimization and analysis process parameter optimization are performed alternately.
[FIG. 11]

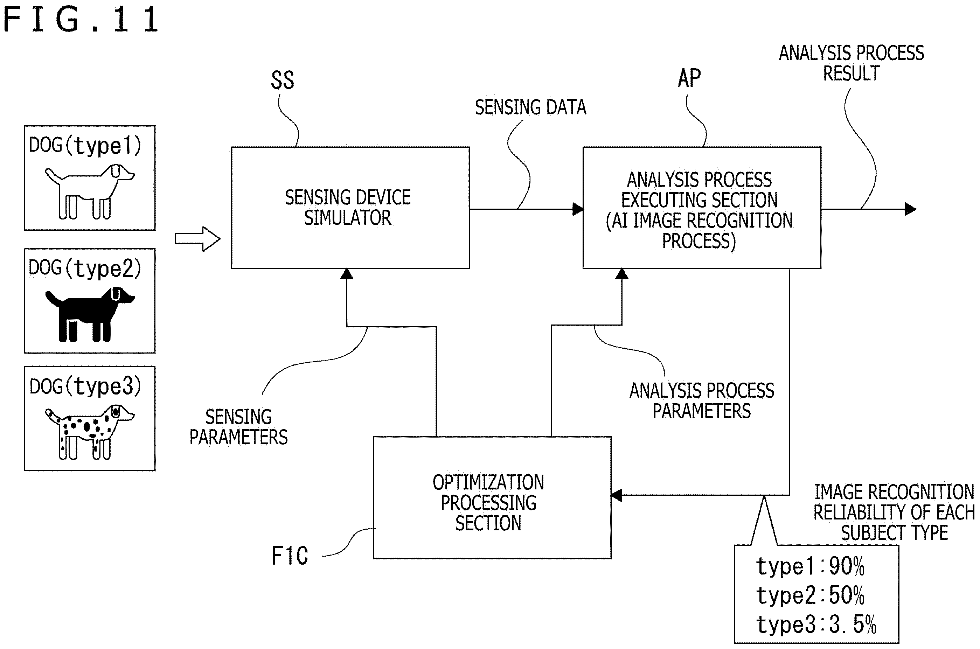

   FIG. 11 is a figure for explaining a parameter optimization approach as a third embodiment.
[FIG. 12]

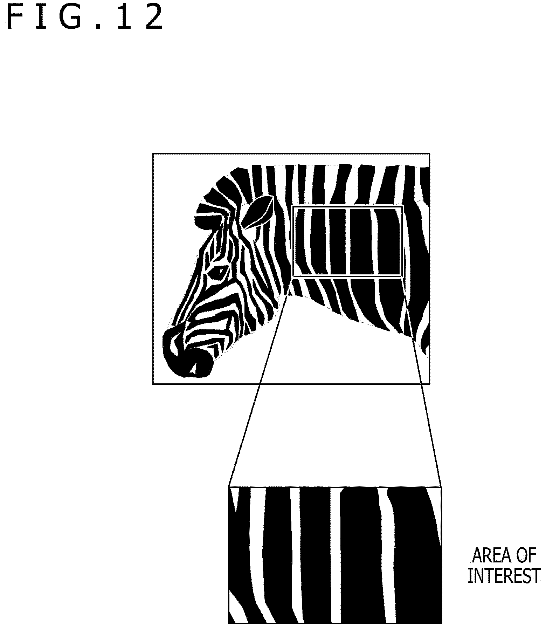

   FIG. 12 is an explanatory diagram of an example of an area of interest.
[FIG. 13]

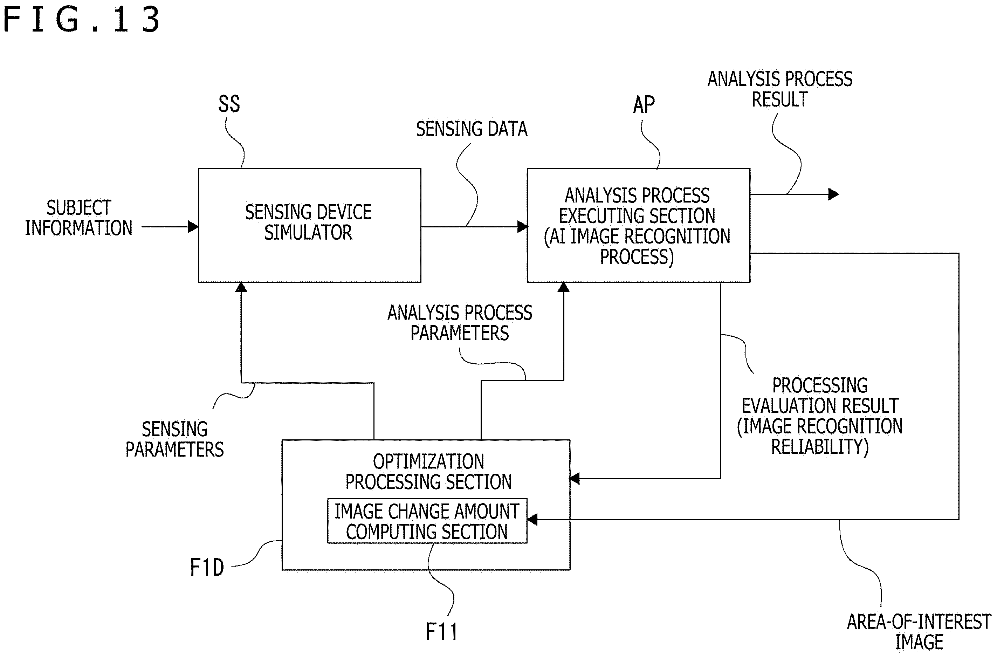

   FIG. 13 is a figure for explaining a parameter optimization approach as a fourth embodiment.
[FIG. 14]

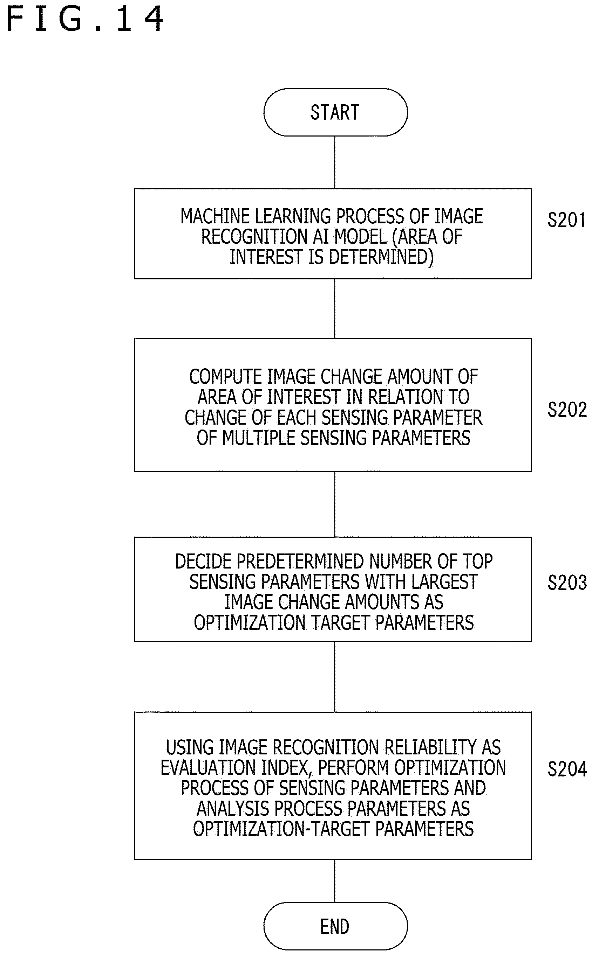

   FIG. 14 is a flowchart depicting a specific processing procedure example in the parameter optimization approach as the fourth embodiment.
[FIG. 15]

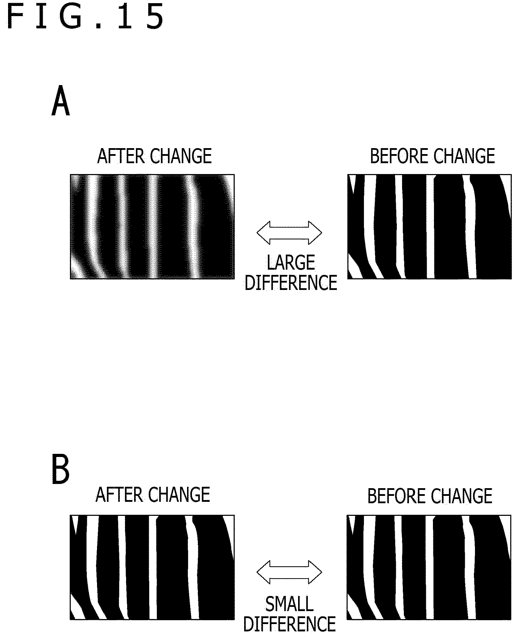

   FIG. 15 depicts figures each for explaining an example of an image change of an area of interest in relation to a change of a sensing parameter.
[FIG. 16]

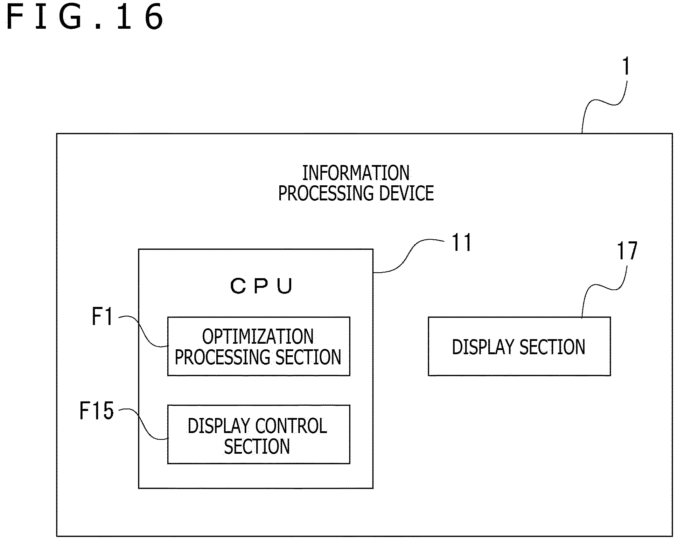

   FIG. 16 is a figure for explaining the configuration of the information processing device having a display control section as the embodiment.
[FIG. 17]

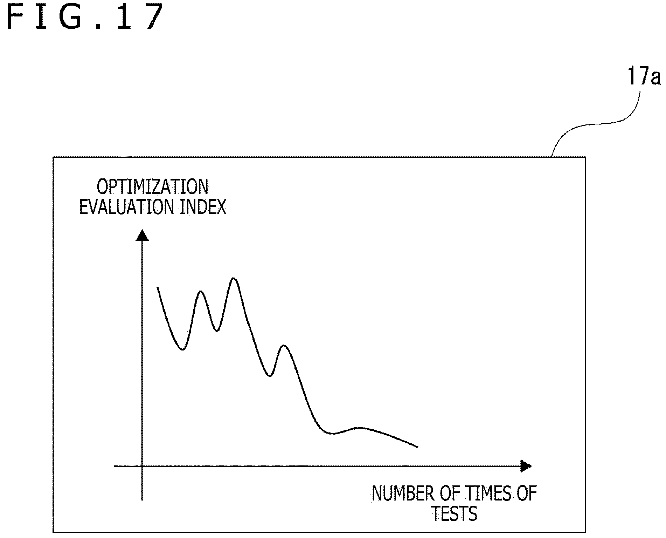

   FIG. 17 is a figure depicting a specific display example of an optimization evaluation index.
[FIG. 18]

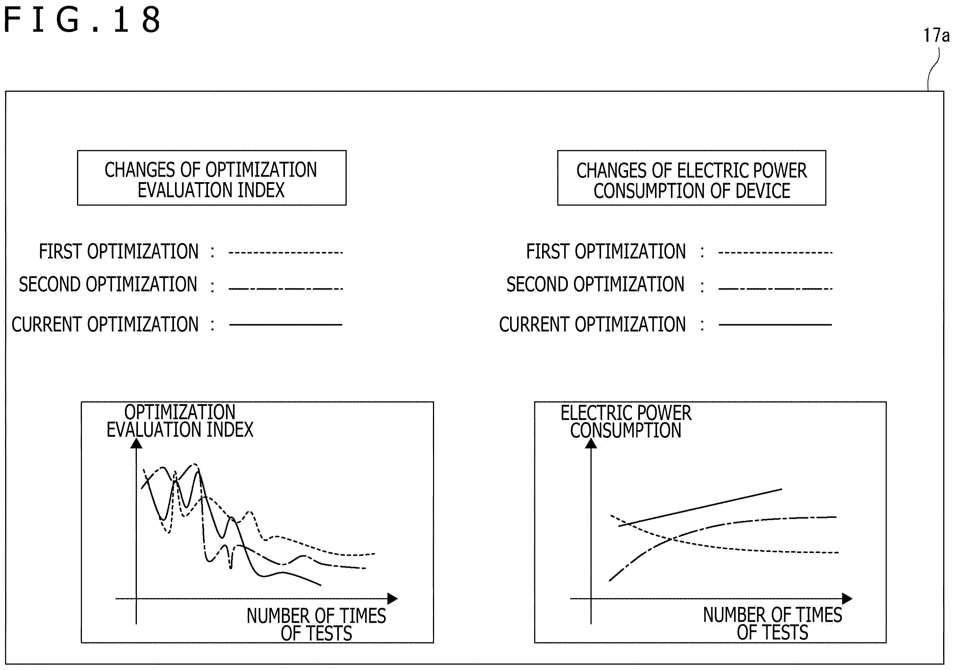

   FIG. 18 is a figure depicting another display example of the optimization evaluation index.
[FIG. 19]

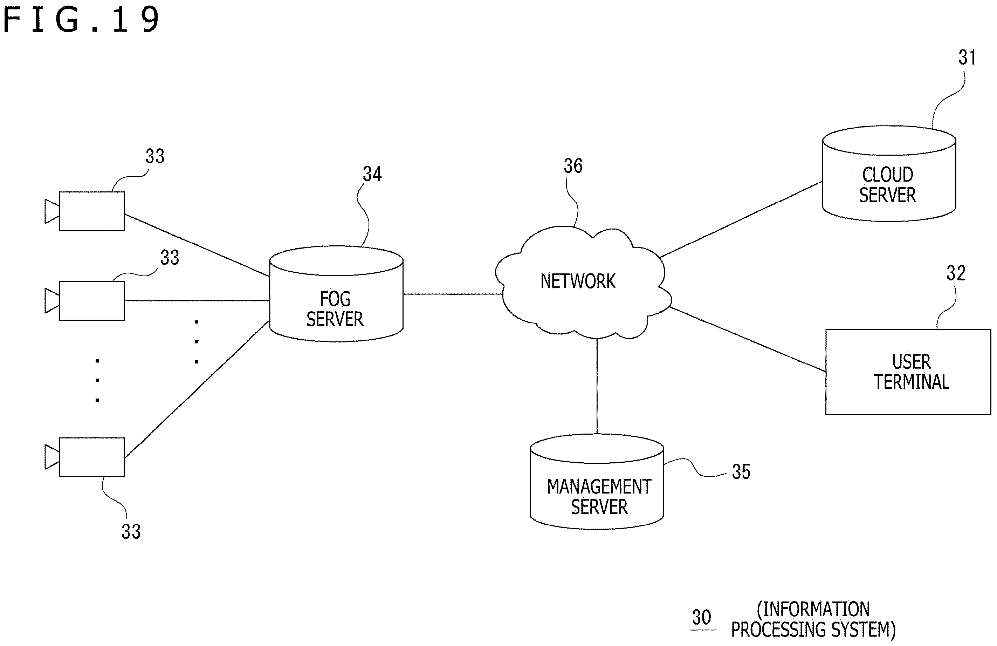

   FIG. 19 is a figure depicting a configuration example of the information processing system.
[FIG. 20]

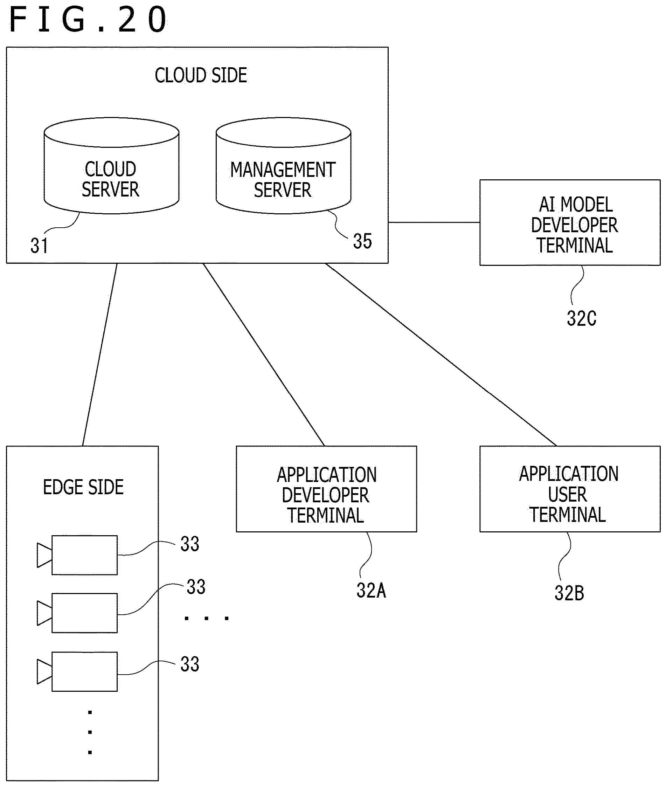

   FIG. 20 is a figure for explaining each piece of equipment that registers or downloads AI models or AI applications via a marketplace function included in a cloud-side information processing device.
[FIG. 21]

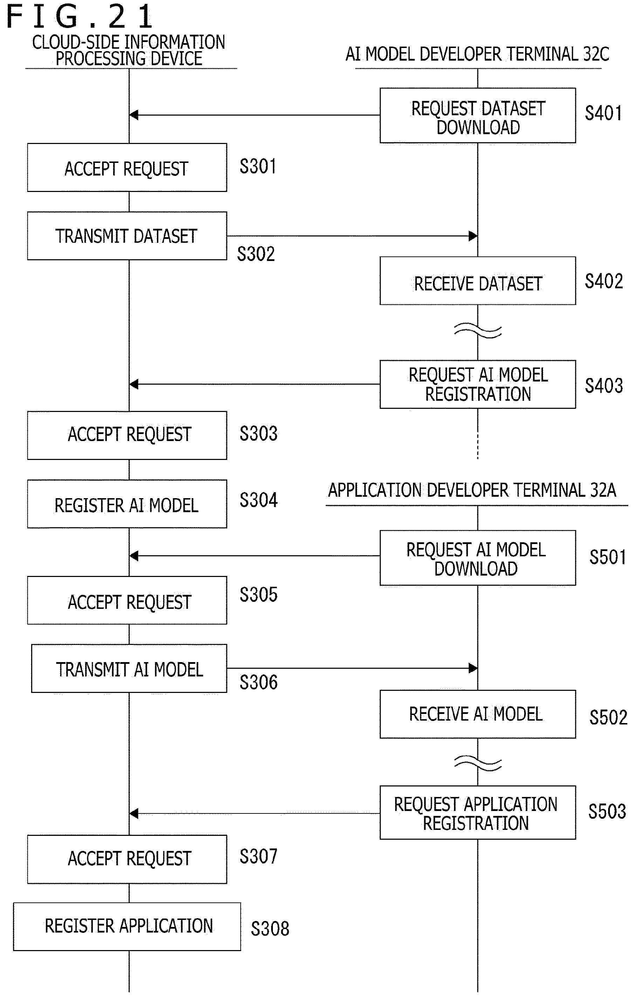

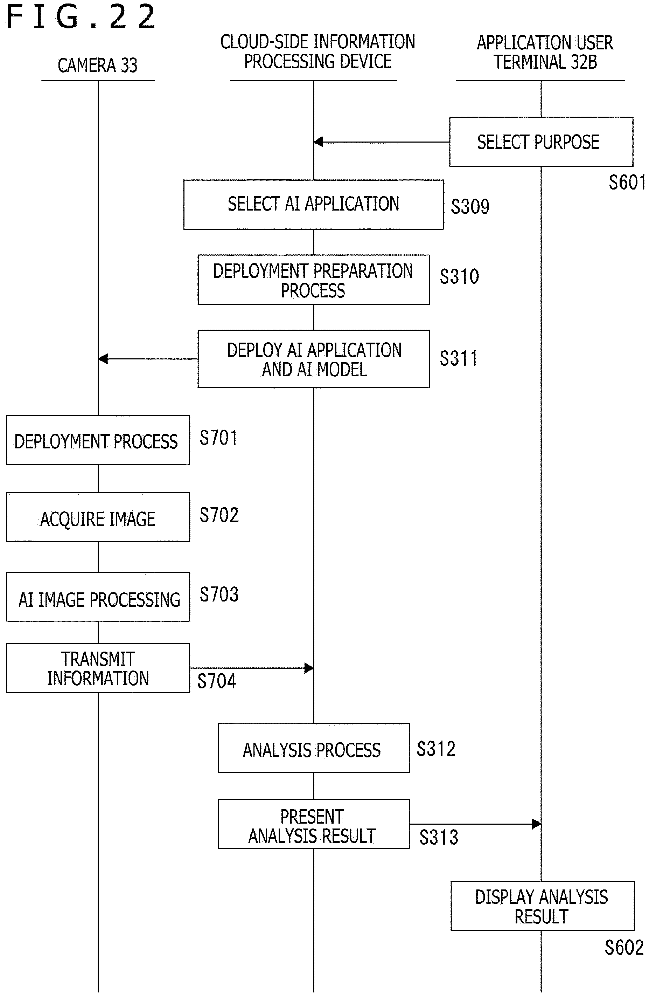

   FIG. 21 is a figure depicting, along with FIG. 22, an example of a processing procedure executed by each device when an AI model or an AI application is registered or downloaded via the marketplace function.
[FIG. 22]
   FIG. 22 is a figure depicting, along with FIG. 21, an example of a processing procedure executed by each device when the AI model or the AI application is registered or downloaded via the marketplace function.
[FIG. 23]

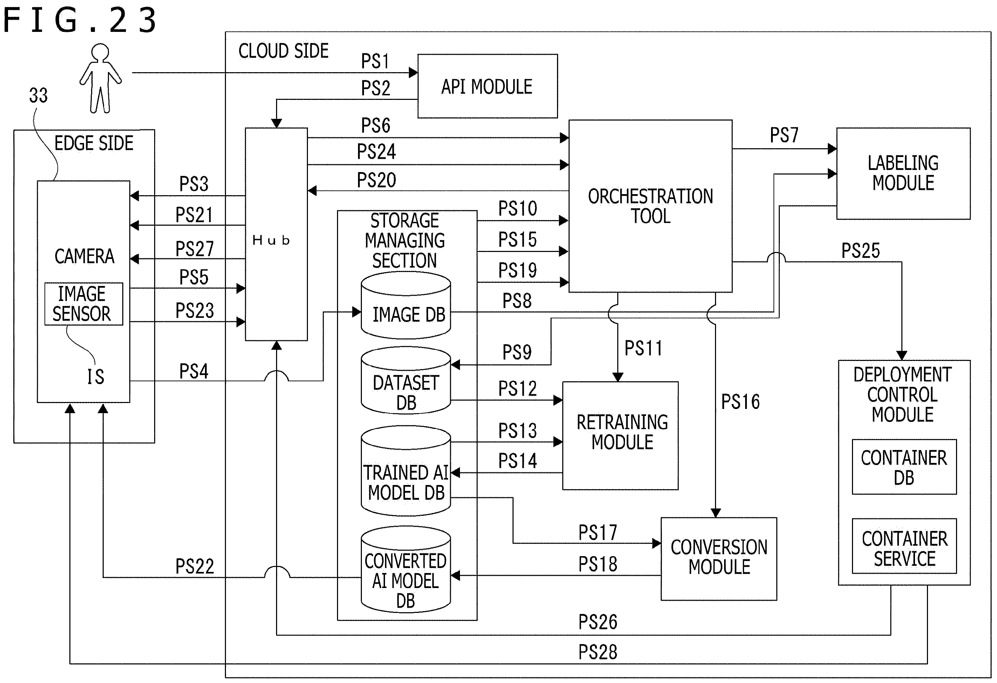

   FIG. 23 is a figure for explaining a processing procedure related to updating of an AI model or an AI application.
[FIG. 24]

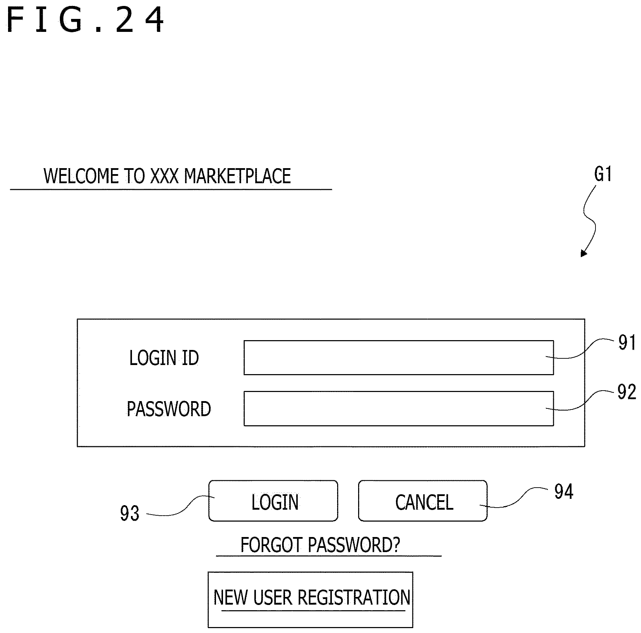

   FIG. 24 is a figure depicting an example of a login screen for logging into a marketplace.
[FIG. 25]

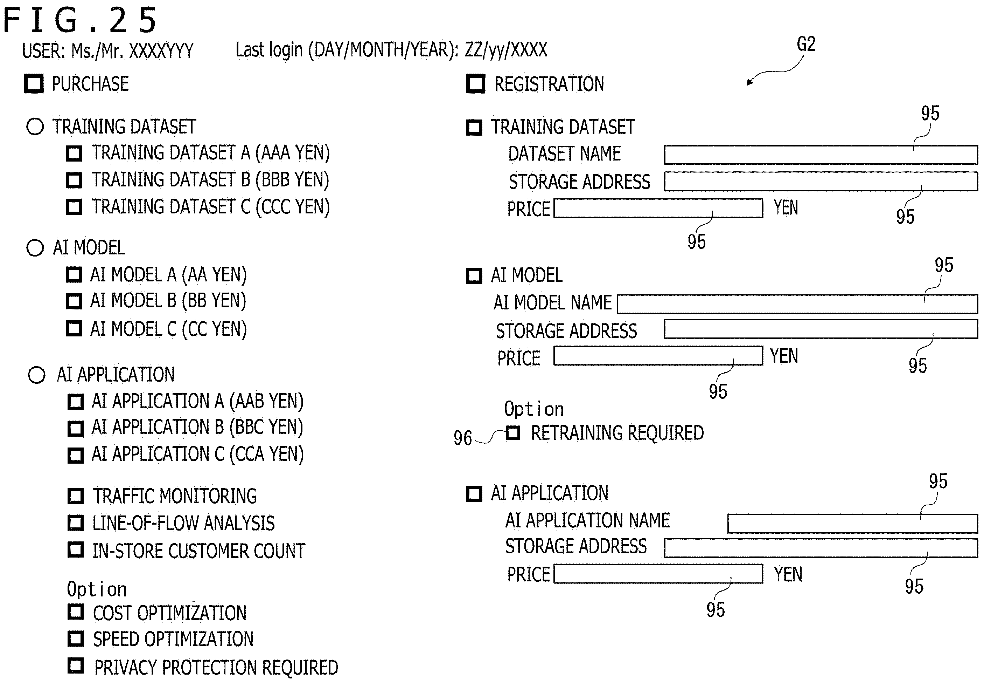

   FIG. 25 is a figure depicting an example of a developer screen presented to each developer who uses a marketplace.
[FIG. 26]

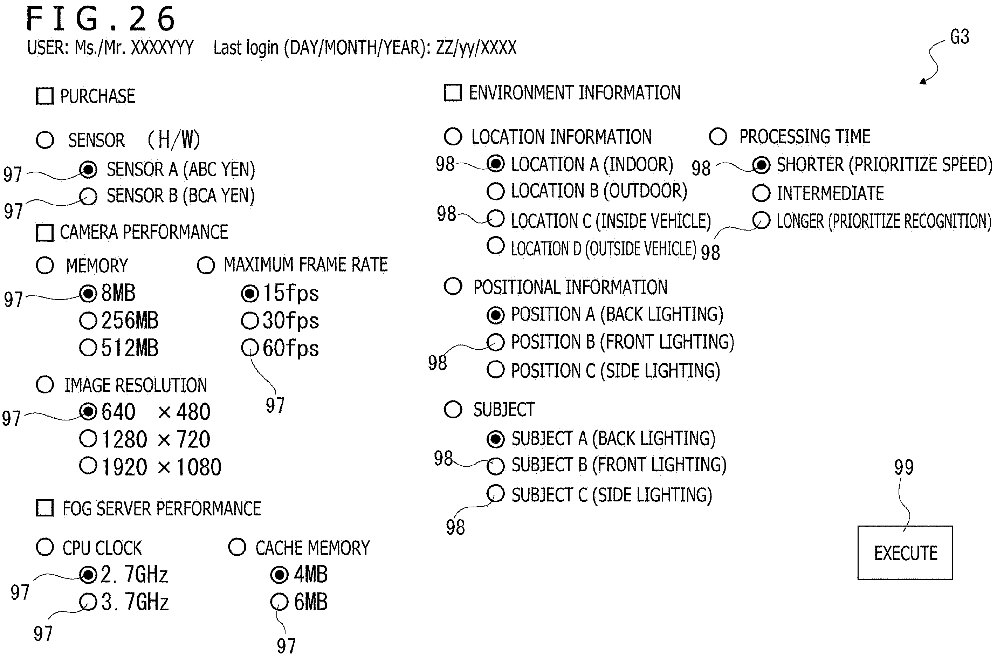

   FIG. 26 is a figure depicting an example of a user screen presented to an application user who uses a marketplace.

### [Description of Embodiments]

Hereinbelow, embodiments according to the present technology are explained in the following order with reference to the attached figures.
<1. First Embodiment>
   (1-1. Overall System Configuration)
   (1-2. Configuration of Information Processing Device)
   (1-3. Regarding Sensing Device Simulator)
   (1-4. Parameter Optimization Approach as First Embodiment)
   (1-5. Another Example of First Embodiment)
<2. Second Embodiment>
<3. Third Embodiment>
<4. Fourth Embodiment>
<5. Regarding UI for Optimization>
<6. Regarding Application Example of Present Technology>
   (6-1. System on Which Application Example Is Premised)
   (6-2. Application Example)
<7. Modification Examples>
<8. Program>
<9. Summary of Embodiments>
<10. Present Technology>

### <1. First Embodiment>

### (1-1. Overall System Configuration)

FIG. 1 is a block diagram depicting a schematic configuration example of an optimization system 100 as a first embodiment according to the present technology including an information processing device 1 as the first embodiment.

As depicted in the figure, the optimization system 100 includes at least the information processing device 1, an information processing device 2, an information processing device 3, and a database 4.

Each of the information processing devices 1, 2, and 3 is configured as a computer device, and the information processing devices 1, 2, and 3 are configured to be capable of performing data communication with each other. Note that, for example, the data communication between the information processing devices 1, 2, and 3 can be performed as data communication via a predetermined communication network such as the Internet in a case where the information processing devices are arranged remotely or in other cases.

The information processing device 1 functions as an optimization processing section F1. In addition, the information processing device 2 functions as a sensing device simulator SS, and the information processing device 3 functions as an analysis process executing section AP.

The analysis process executing section AP performs an analysis process on sensing data obtained by a sensing device, on the basis of set parameters.

The sensing device simulator SS estimates the sensing data described above, on the basis of set parameters.

On the basis of evaluation results of the analysis process performed by the analysis process executing section AP using, as an input, the sensing data estimated by the sensing device simulator SS, the optimization processing section F1 updates and optimizes the parameters of the sensing device simulator SS and the parameters of the analysis process executing section AP.

Hereinbelow, it is supposed in the explanation of the embodiments that a target sensing device, that is, a simulation-target sensing device of the sensing device simulator SS, is an image capturing device.

"Image capturing" here broadly means obtaining image data regarding captured images of subjects. Image data here collectively refers to data including multiple pieces of pixel data, and the concept of pixel data broadly covers not only data representing amounts of light received from subjects with a predetermined number of levels of greyscale values, but also, for example, the distances to subjects, polarization information, temperature information, and the like. That is, "image data" (sensing data) obtained by "image capturing" includes data as greyscale images representing the greyscale value of an amount of received light for each pixel, data as distance images representing information regarding the distance to a subject for each pixel, data as polarization images representing polarization information for each pixel, data as thermal images representing temperature information for each pixel, and the like.

In addition, "image data" can also include event images obtained by what is generally called an EVS (Event-based Vision Sensor). Events here mean those that involve amounts of received light that change by a predetermined amount or greater, and "event images" are images representing information regarding whether or not an event has occurred for each pixel.

As an example, it is supposed hereinbelow that the target sensing device is configured as an image capturing device (camera) including a greyscale sensor that obtains greyscale images similarly to a typical image sensor such as an RGB sensor. For example, the greyscale sensor here is configured as a CCD (Charge Coupled Device) type image sensor, a CMOS (Complementary Metal Oxide Semiconductor) type image sensor, or the like.

The database 4 includes a computer device, and, as depicted in the figure, has stored thereon a subject information group 4a, a sensing parameter group 4b, and an analysis process parameter group 4c.

The subject information group 4a represents a set of multiple pieces of subject information which are candidates of subject information that should be given as an input of the sensing device simulator SS.

It is supposed in the present example that an image data simulation by the sensing device simulator SS is performed using a three-dimensional CG (Computer Graphics) model. In this case, the subject information includes data representing the shapes of three-dimensional CG models, information representing the orientations (angles) of the three-dimensional CG models, the distances of the three-dimensional CG models from an image capturing device, and the colors of the three-dimensional CG models, and information regarding light sources that illuminate the three-dimensional CG models (information regarding light source colors, etc.).

Note that an image data simulation by the sensing device simulator SS is performed using imaged subject information in some cases, and, in those cases, the subject information includes information regarding color balance or contrast, for example.

The sensing parameter group 4b represents a set of multiple parameters which are candidates of parameters that can be set for the sensing device simulator SS (hereinafter, described as "sensing parameters").

Note that specific types of the sensing parameters in the present example are explained later on along with the configuration of the sensing device simulator SS.

The analysis process parameter group 4c represents a set of multiple parameters which are candidates of parameters that can be set for the analysis process executing section AP (hereinafter, described as "analysis process parameters").

In the present example, as an image capturing device simulator, the sensing device simulator SS estimates a captured image, and, corresponding to this, the analysis process by the analysis process executing section AP is an image analysis process. Because of this, the analysis process parameters stored as the analysis process parameter group 4c are parameters related to the image analysis process.

In the optimization system 100 in the present example, while the optimization processing section F1 serially updates the set parameters of the sensing device simulator SS and the analysis process executing section AP by using the sensing parameters and the analysis process parameters stored as the sensing parameter group 4b and the analysis process parameter group 4c on the database 4, the optimization processing section F1 searches for optimum sensing parameters and analysis process parameters on the basis of evaluation results of the analysis process by the analysis process executing section AP obtained for each parameter setting state. That is, the sensing parameters and the analysis process parameters are optimized.

Optimization of the parameters here means deriving (searching for) parameters with which a predetermined purpose related to analysis process results is achieved.

### (1-2. Configuration of Information Processing Device)

FIG. 2 is a block diagram depicting a hardware configuration example of the information processing device 1 depicted in FIG. 1. Note that examples of the hardware configurations of the information processing devices 2 and 3 and the database 4 are similar to the one depicted in this figure, and accordingly overlapping explanations are avoided.

As depicted in the figure, the information processing device 1 includes a CPU 11.

The CPU 11 executes various types of processes according to programs stored on a ROM 12 or a non-volatile memory section 14 such as an EEP-ROM (Electrically Erasable Programmable Read-Only Memory), for example, or programs loaded from a storage section 19 onto a RAM 13. Also, data necessary for execution of the various types of processes by the CPU 11, for example, is stored as appropriate on the RAM 13.

The CPU 11, the ROM 12, the RAM 13, and the non-volatile memory section 14 are interconnected via a bus 23. The bus 23 is also connected with an input/output interface (I/F) 15.

The input/output interface 15 is connected with an input section 16 including a control element or an operation device. For example, it is supposed that the input section 16 is any of various types of control elements or operation devices such as a keyboard, a mouse, a key, a dial, a touch panel, a touch pad, or a remote controller.

User operation is sensed by the input section 16, and a signal according to the input operation is interpreted by the CPU 11.

In addition, the input/output interface 15 is connected with, as an integrated body or separate bodies, a display section 17 including an LCD (Liquid Crystal Display), an organic EL (Electro-Luminescence) panel, or the like and a sound output section 18 including a speaker or the like.

The display section 17 is used for displaying various types of information, and includes, for example, a display device provided to a housing of the computer device, a display device which is a separate body connected to the computer device, or the like.

The display section 17 executes displaying of images for various types of image processing, processing-target videos, and the like on a display screen on the basis of instructions of the CPU 11. In addition, the display section 17 displays various types of operation menus, icons, messages, or the like, that is, performs displaying as a GUI (Graphical User Interface), on the basis of instructions of the CPU 11.

The input/output interface 15 is connected with the storage section 19 including a HDD (Hard Disk Drive), a solid memory, or the like and a communicating section 20 including a modem or the like, in some cases.

The communicating section 20 performs a communication process via a transfer path such as the Internet, wired/wireless communication with various types of equipment, and communication by bus communication or the like.

The input/output interface 15 is also connected with a drive 21 as necessary, and a removable storage medium 22 such as a magnetic disc, an optical disc, a magneto-optical disc, or a semiconductor memory is attached to the drive 21 as appropriate.

The drive 21 makes it possible to read out, from the removable storage medium 22, data files of programs or the like used for processes and the like. The data files having been read out are stored on the storage section 19, images or sounds included in the data files are output at the display section 17 or the sound output section 18, and so on. In addition, computer programs or the like having been read out from the removable storage medium 22 are installed on the storage section 19 as necessary.

On the computer device having such a hardware configuration as the one described above, for example, software for processes of the present embodiment can be installed via network communication by the communicating section 20 or via the removable storage medium 22. Alternatively, the software may be stored in advance on the ROM 12, the storage section 19, or the like.

By the CPU 11 performing processing operations on the basis of various types of programs, necessary information processes or communication processes such as the processes by the optimization processing section F1 described before are executed.

Note that the information processing device 1 is not necessarily configured singly by such a computer device as the one depicted in FIG. 2, and may be configured by systemization of multiple computer devices. The multiple computer devices may be systemized by a LAN (Local Area Network) or the like, or may be arranged remotely using a VPN (Virtual Private Network) or the like using the Internet or the like. The multiple computer devices may include a computer device as a server group (cloud) that can be used by a cloud computing service.

### (1-3. Regarding Sensing Device Simulator)

FIG. 3 is a figure depicting a configuration example of the sensing device simulator SS.

As described before, the sensing device simulator SS in the present example is configured as a simulator targeted at an image capturing device, and, as depicted in the figure, functions as a lens section S1, a color filter S2, an I/V converting section S3, an electric-charge/voltage converting section S4, a fixed noise adding section S5, a random noise adding section S6, an analog gain section S7, and an A/D converting section S8.

It is made possible for the sensing device simulator SS in this case to set one or more parameters (sensing parameters) for each section.

The lens section S1 calculates a light image projected onto a sensor surface (light reception surface), by computing how light from a subject is transmitted through a lens, on the basis of subject information given as an input of the sensing device simulator SS.

Examples of parameters that can be set for the lens section S1 include parameters related to lens distortion, shading, PSF (blur function), focal length, and the like.

On the basis of the light image calculated by the lens section S1, the color filter S2 splits light incident on each pixel, and calculates light amounts.

Examples of parameters that can be set for the color filter S2 include parameters related to the pixel count (image resolution such as 4K or FHD), the pixel size, the filter array (Bayer array, QBC, etc.), spectral characteristics (e.g., wavelength-transmittance characteristics), and the like.

The I/V converting section S3 converts light with the amounts of light calculated by the color filter S2 into electric charges.

Examples of parameters include parameters related to the saturation electron count, exposure time, and the like.

The electric-charge/voltage converting section S4 converts the electric charges calculated by the I/V converting section S3 into voltages.

Examples of parameters include parameters related to conversion efficiency and the like.

The fixed noise adding section S5 performs fixed noise addition to the voltages (voltage of each pixel) calculated at the electric-charge/voltage changing section S4. Note that it is supposed that target fixed noise here is mainly one that is dependent on pixel defects or the circuit pattern.

Examples of parameters include parameters related to a noise value and the like.

The random noise adding section S6 performs random noise addition to the voltage of each pixel on which the noise addition by the fixed noise adding section S5 has been performed. It is supposed that the random noise here is mainly thermal noise.

Examples of parameters include parameters related to the noise value and the like.

The analog gain section S7 applies a designated gain to the voltage of each pixel on which the noise addition by the random noise adding section S6 has been performed.

Examples of parameters include parameters related to the gain value and the like.

The A/D converting section S8 converts the values of the voltages to which the gains have been applied by the analog gain section S7 into digital values with designated bit sizes.

Examples of parameters include parameters related to the bit size and the like.

By the process by the A/D converting section S8 described above, sensing data as image data representing, by a digital value, the amount of received light for each pixel is obtained. In the present example, the image data is output data of the sensing device simulator SS.

Note that the configuration described above of the sensing device simulator SS for an image capturing device is merely an example, and it is also possible that the configuration does not include the lens section S1 or the color filter S2, for example. The configuration of the sensing device simulator SS may be a lens-less configuration or may be a configuration in which a scatter board is arranged or a mask or the like having physical openings or the like is arranged.

In addition, it is also possible that the output image data accompanies information regarding subjects such as the names of the subjects or subject areas on the image.

### (1-4. Parameter Optimization Approach as First Embodiment)

A parameter optimization approach as the first embodiment is explained with reference to FIG. 4.

First, the present example is based on the premise that the analysis process by the analysis process executing section AP is an image recognition process (hereinafter, described as an "AI image recognition process" in some cases) using an artificial intelligence model.

There is a variety of specific function types of the AI image recognition process, and, for example, examples thereof include function types illustrated below.
- Class identification (including semantic segmentation)
- Human sensing
- Vehicle sensing
- OCR (Optical Character Recognition)

Among the function types described above, class identification is a function to identify the classes of targets. The classes here are information representing the categories of objects, and, for example, are ones that make distinctions between "human," "automobile," "airplane," "ship," "truck," "bird," "cat," "dog," "horse," and the like.

In the present example, for example, the AI image recognition process is performed as a process using a DNN (Deep Neural Network) such as a CNN (Convolutional Neural Network). In this case, examples of the analysis process parameters described before include a parameter that designates the size or a convolution coefficient of a kernel for performing convolution computation, a parameter that designates the network structure of the neural network (hyperparameters, etc.), or the like.

Here, the optimization processing section F1 in the present example uses, as an evaluation index in parameter optimization, an image recognition reliability calculated in the AI image recognition process.

Whereas a reliability (likelihood) of results of image recognition is typically computed in an AI image recognition process, information regarding a reliability of image recognition results computed in the AI image recognition process in such a manner is used as an evaluation index in parameter optimization in the present example. That is, a set of sensing parameters and analysis process parameters that can make the reliability a favorable value is searched for.

Hereinbelow, a reliability of image recognition results computed in the AI image recognition process as described above is described as an "image recognition reliability."

Information regarding the image recognition reliability is an example of information representing evaluation results of the analysis process by the analysis process executing section AP.

Here, parameter optimization in the present example is performed on the premise that a user as an operator designates various types of conditions related to the optimization process for the information processing device 1 (optimization processing section F1) by, for example, operation on a control element in the input section 16 or the like.

For example, examples of the condition designation here include designation of conditions related to sensing parameters and analysis process parameters that should be tested in an optimization process, specifically, designation as to which parameters among multiple sensing parameters and analysis process parameters stored as the sensing parameter group 4b and the analysis process parameter group 4c are used in an optimization process.

In addition, examples of the condition designation here include designation as to what type of information is used as subject information in an optimization process.

The optimization processing section F1 in the present example performs control using parameters and subject information according to the condition designation, such that the image data estimation process by the sensing device simulator SS for optimization and the AI image recognition process by the analysis process executing section AP based on estimated image data are executed.

Here, in a parameter optimization process, basically, a process in which the image estimation by the sensing device simulator SS and the AI image recognition process by the analysis process executing section AP are executed in a state where sensing parameters and analysis process parameters selected according to the condition designation described above are set and information regarding an image recognition reliability obtained at that time is acquired is repeated multiple times while parameters to be set are serially updated.

As the simplest form, it is possible that a parameter set (a set of sensing parameters and analysis process parameters) that has given the highest image recognition reliability in the course of such a repetitive process is decided as an optimum parameter set.

Just to make sure, a processing procedure example for acquiring evaluation result information regarding the analysis process for each parameter set is depicted in a flowchart in FIG. 5. The process depicted in this figure is equivalent to a process by the optimization processing section F1, and the section that executes the process is the CPU 11 depicted in FIG. 2.

First, in step S101, the CPU 11 sets a parameter set identifier n to 0. The parameter set identifier n is a value for identifying a target parameter set among multiple sets of sensing parameters and analysis process parameters, that is, parameter sets, designated as ones to be tested in an optimization process.

In step S102 subsequent to step S101, the CPU 11 performs a process of setting an n-th parameter set. That is, this is a process of setting, for the sensing device simulator SS and the analysis process executing section AP, respectively, sensing parameters and analysis process parameters identified as the n-th parameter set.

In step S103 subsequent to step S102, the CPU 11 gives an instruction for executing sensing data generation and analysis processes. That is, the CPU 11 gives the sensing device simulator SS an instruction for executing a simulation, to cause the sensing device simulator SS to generate image data, and gives the analysis process executing section AP an instruction for executing the AI image recognition process using the generated image data as an input.

Here, in a case where the analysis process executing section AP performs the AI image recognition process as in the present example, it is also possible that machine learning (e.g., deep learning) of an AI model that executes the AI image recognition process is performed in the course of the optimization of the analysis process parameters. In a case where the contents of image data to be input to the AI model need to be modified as appropriate in this machine learning, the CPU 11 (optimization processing section F1) performs a process of modifying subject information as necessary before giving the instructions for execution of step S103.

In step S104 subsequent to step S103, the CPU 11 acquires evaluation result information regarding the analysis process. That is, information regarding an image recognition reliability calculated in the AI image recognition process executed in step S103 is acquired.

In step S105 subsequent to step S104, the CPU 11 assesses whether or not the parameter set identifier n is equal to or greater than an upper limit value nMAX. For example, the upper limit value nMAX is the total number of parameter sets designated in the condition designation described before, or the like.

In a case where it is assessed in step S105 that the parameter set identifier n is not equal to or greater than the upper limit value nMAX, the CPU 11 proceeds to step S106, increments the parameter set identifier n by one, and returns to step S102.

As a result, for the next parameter set, a process for acquiring evaluation result information regarding the analysis process (information regarding an image recognition reliability in the present example) is performed.

Meanwhile, in a case where it is estimated in step S105 that the parameter set identifier n is equal to or greater than the upper limit value nMAX, the CPU 11 ends the series of processing depicted as FIG. 5.

Here, the approach to parameter optimization is not limited to the approach described above, and can be any of diverse approaches. For example, whereas evaluation result information regarding the analysis process is acquired for each of multiple parameter sets and a parameter set that gives the most favorable evaluation results is decided as an optimum parameter set in the approach in the description above, instead of this, it is also possible that gradient descent, experimental design, an approach using a genetic algorithm, an approach using a regression analysis algorithm such as Ridge regression or Lasso regression, or the like is used.

As an example, an approach to optimizing the sensing parameters and the analysis process parameters using a genetic algorithm is depicted in FIG. 6.

First, a first-generation parameter set group is prepared, and, for each parameter set, for example, the process in FIG. 5 is performed to obtain evaluation result information regarding the analysis process. At this time, the first-generation parameter set group may be determined randomly within the range of possible values of the parameters. Alternatively, in order to enhance the ease of convergence of the optimization process or shorten required time, a parameter set that has been proven in the past (e.g., parameters that have been proven to be of use for actual products in the past, etc.) may be set.

On the basis of evaluation result information regarding each first-generation parameter set, for example, a predetermined number of top parameter sets with the most favorable evaluation results (the highest image recognition reliabilities in the present example) are selected, and crossovers or mutations are given to the top parameter sets to thereby generate a second-generation parameter set group. Hereinafter, similar processes are repeated until sufficiently favorable evaluation results are obtained, and the sensing parameters and the analysis process parameters are gradually optimized.

### (1-5. Another Example of First Embodiment)

Whereas the analysis process by the analysis process executing section AP is the AI image recognition process in the example in the description above, it is also possible that the analysis process by the analysis process executing section AP is not a process using an AI model, but a rule-based process.

Here, a case where the image analysis process by a rule-based process is an object area sensing process based on contour sensing is illustrated as an example.

FIG. 7 is an explanatory diagram of a parameter optimization approach as another example of the first embodiment.

Note that, hereinbelow, portions that are similar to portions that have already been explained are given identical reference signs, and explanations thereof are omitted.

In this case, the analysis process executing section AP performs the object area sensing process based on contour sensing (edge sensing) targeted at image data generated by the sensing device simulator SS. It is sufficient if the contour sensing uses a known algorithm, and the analysis process parameters in this case are parameters of a contour sensing algorithm.

It is possible that, for example, as processing result information regarding the object area sensing process, a binarized image in which only sensed object areas are set to "1" and other areas are set to "zero," for example, is output.

Here, such an object area sensing process as the one described above is an example of a process of sensing particular things.

Corresponding to the analysis process being the process of sensing particular things as described above, in the present example, an amount of sensing error of the process of sensing is used as an evaluation index in optimization.

Specifically, an amount-of-sensing-error computing section F5 that calculates an amount of sensing error on the basis of analysis process results (results of sensing particular things) of the analysis process executing section AP is provided as depicted in the figure, and the amount of sensing error computed by the amount-of-sensing-error computing section F5 is used as an evaluation index in parameter optimization.

An example of an amount-of-sensing-error computation approach is explained with reference to FIG. 8.

In a case illustrated here, a sensing-target object is a wrench.

Due to the influence of noise or the like generated in an image, a sensing error of an object can occur in the object area sensing process based on contour sensing. That is, areas where there are no objects are erroneously and undesirably sensed as object areas.

In this case, an amount of sensing error is calculated using an image representing a correct answer area of a target object as depicted in the figure. Specifically, a difference image representing the difference between an object area sensing image (the binarized image described above) obtained as analysis process results of the analysis process executing section AP and the correct answer area image of the target object is generated, and the number of object sensing areas remaining in the difference image is calculated as an amount of sensing error.

Note that it is possible that the function as the amount-of-sensing-error computing section F5 in FIG. 7 is configured as being realized by the CPU 11 of the information processing device 1. Alternatively, it is also possible that the function as the amount-of-sensing-error computing section F5 is configured as being realized by a CPU of the information processing device 2 having the analysis process executing section AP or is configured as being realized by a CPU of another information processing device other than the information processing devices 1, 2, and 3, for example.

In FIG. 7, the optimization system 100 in this case is provided with an optimization processing section F1A instead of the optimization processing section F1. The optimization processing section F1A uses, as an evaluation index in parameter optimization, the amount of sensing error input by the amount-of-sensing-error computing section F5. Specifically, as a parameter optimization process, for example, the optimization processing section F1A performs a process of searching for a parameter set that makes the amount of sensing error input by the amount-of-sensing-error computing section F5 equal to or smaller than a predetermined value.

As a result, it is possible to optimize the parameters of each of the sensing device simulator and the analysis process executing section by the appropriate evaluation index that can cope with a case where the analysis process by the analysis process executing section is the process of sensing particular things.

Here, whereas the first embodiment is based on the premise that parameter optimization is performed by only one type of approach such as performing the optimization only by the approach using the genetic algorithm if the genetic algorithm is used, for example, it is also possible that the approach to parameter optimization (the approach to parameter set selection) is modified in the course of the optimization.

### <2. Second Embodiment>

Next, a second embodiment is explained.

The second embodiment is an example in which information other than evaluation results of the analysis process is also used as an evaluation index in optimization. In an example explained below, device specification evaluation values which are specification evaluation values of a target sensing device (an image capturing device in the present example) are used as information other than evaluation results of the analysis process.

FIG. 9 is a figure for explaining a parameter optimization approach as the second embodiment.

Note that, since the second embodiment as well as the third and fourth embodiments explained below are similar to the case depicted in FIG. 1 in that the optimization system 100 includes the information processing devices 1, 2, and 3 and the database 4, overlapping explanations are omitted.

As depicted in the figure, the optimization system 100 in this case is different from that in the first embodiment in that the optimization system 100 is provided with an optimization processing section F1B instead of the optimization processing section F1.

The optimization processing section F1B has a specification evaluating section F10 that calculates the device specification evaluation values.

Here, for example, it is possible that evaluation of sensing device specifications to be performed is evaluation of the electric power consumption, manufacturing cost, the device size (housing size), ease of designing, and the like of the sensing device. In addition, particularly in a case where the target sensing device is an image capturing device as in the present example, it is also possible that evaluation of sensing device specifications to be performed is evaluation of such items as the focus blurring amount that influence the contents of images to be generated.

As depicted in the figure, the specification evaluating section F10 receives, in a branched manner, an input of sensing parameters to be set for the sensing device simulator SS by the optimization processing section F1B. The specification evaluating section F10 performs a process of calculating the device specification evaluation values on the basis of the thus-input sensing parameters.

For example, in a case where the sensing devices is an image capturing device, the electric power consumption or the manufacturing cost is correlated with a parameter related to the pixel count, a parameter related to the bit size of A/D conversion, and the like included in the sensing parameters, and the device size is also correlated with a parameter related to the pixel count and the like. In addition, the focus blurring amount is correlated with a parameter related to a PFS and the like included in the sensing parameters. In such a manner, the device specification evaluation values are ones that are correlated with parameters regarding corresponding items in the sensing parameters, and ones that can be estimated from the parameters regarding the corresponding items if their correlations are known.

In the present example, for example, the specification evaluating section F10 calculates the target device specification evaluation values from the sensing parameters by using functions or table information for estimating the target device specification evaluation values such as the electric power consumption from the parameters of the corresponding items in the sensing parameters.

The electric power consumption is calculated as a device specification evaluation value in an example here.

The optimization processing section F1B performs a parameter optimization process by using, as evaluation indices in parameter optimization, the value of the electric power consumption calculated as a device specification evaluation value by the specification evaluating section F10 and information regarding an image recognition reliability as evaluation result information regarding the analysis process by the analysis process executing section AP.

Specifically, the optimization processing section F1B performs a process of searching for a parameter set that minimizes the electric power consumption within such a range that a condition that the image recognition reliability is kept equal to or greater than a certain value is satisfied.

As a result, design optimization of each of the sensing device and the analysis process can be performed such that the electric power consumption of the sensing device can be reduced as much as possible within such a range that the analysis process satisfies a predetermined performance condition.

Here, in a case where the manufacturing cost is used as a device specification evaluation value, the optimization processing section F1B performs a process of searching for a parameter set that minimizes the manufacturing cost within such a range that a condition that the image recognition reliability is kept equal to or greater than a certain value is satisfied.

As a result, design optimization of each of the sensing device and the analysis process can be performed such that the manufacturing cost of the sensing device can be reduced as much as possible within such a range that the analysis process satisfies a predetermined performance condition.

Note that, in a case where the housing size is used as a device specification evaluation value, it is possible that the optimization processing section F1B performs a process of searching for a parameter set that minimizes the housing size within such a range that a condition that the image recognition reliability is kept equal to or greater than a certain value is satisfied.

In addition, in a case where the ease of designing is used as a device specification evaluation value, it is possible that the optimization processing section F1B performs a process of searching for a parameter set that maximizes the ease of designing within such a range that a condition that the image recognition reliability is kept equal to or greater than a certain value is satisfied.

In addition, as described above, the focus blurring amount can also be used as a device specification evaluation value.

In a case where the focus blurring amount is used as a device specification evaluation value, the optimization processing section F1B performs a process of searching for a parameter set that maximizes the focus blurring amount within such a range that a condition that the image recognition reliability is kept equal to or greater than a certain value is satisfied.

As a result, while the performance of the image analysis process is kept equal to or greater than certain performance, design optimization of each of the sensing device and the analysis process can be performed such that it is possible to attempt to protect privacy of a subject even in a case where a sensing image captured by the image capturing device is leaked.

Here, in a case where multiple evaluation indices are used in parameter optimization as in the second embodiment, it is also possible that optimization of the sensing parameters and optimization of the analysis process parameters are performed alternately while the main evaluation index is switched from one to another.

A specific example is explained with reference to a flowchart in FIG. 10.

Whereas the focus blurring amount is used as a device specification evaluation value in a case explained here as an example, it is sufficient if parameter optimization is performed by a similar procedure also in a case where another device specification evaluation value such as the electric power consumption is used.

In this case, in step S10, the CPU 11 performs a process of optimizing the sensing parameters such that, while the analysis process parameters are fixed, the focus blurring amount is maximized within such a range that the image recognition reliability does not fall below a predetermined percentage.

At this time, for example, it is possible that parameters that have been proven in the past or the like are used as the analysis process parameters.

Next, in step S11, the CPU 11 performs a process of optimizing the analysis process parameters such that the image recognition reliability is enhanced as much as possible while the sensing parameters are fixed at the sensing parameters determined by the optimization in step S10.

This is equivalent to performing machine learning of an image recognition AI model in a state where the sensing parameters are fixed, in a case where the analysis process executing section AP performs an AI image recognition process as in the present example.

In still subsequent step S12, the CPU 11 performs a process of optimizing the sensing parameters such that, while the analysis process parameters are fixed at the parameters determined in the optimization in step S11, the focus blurring amount is maximized within such a range that the image recognition reliability does not fall below a predetermined percentage.

Note that the process in this case may end in step S12, or, after step S12, the set of the processes in step S11 and step S12 may be repeated a predetermined number of times. In step S11 in this repetition, the sensing parameters are fixed at sensing parameters determined in the optimization in step S12 that is executed immediately before.

By the approach in which optimization of the sensing parameters and optimization of the analysis process parameters are performed alternately while the main evaluation index is switched from one to another as described above, the ease of convergence can be enhanced.

Here, the sensing parameters and the analysis process parameters may be optimized by different approaches in the approach illustrated in FIG. 10. For example, it is possible that the sensing parameters are optimized by an approach using a genetic algorithm, the analysis process parameters are optimized by an approach using gradient descent, and so on.

In addition, in the second embodiment, parameter optimization may be optimized as a neural network by defining both the sensing parameters and the analysis process parameters such that they can back-propagate in differentiable forms.

In addition, it is also possible that the focus blurring amount is calculated on the basis of the contrast value of image data generated by the sensing device simulator SS. That is, in this case, it is unnecessary to input sensing parameters in calculation of the focus blurring amount.

In addition, in the second embodiment, for example, multiple conditions other than evaluation result information regarding the analysis process can also be defined in optimization by using, as evaluation indices in optimization, not only the electric power consumption but also the manufacturing cost, for example.

For example, in a case where both the electric power consumption and the manufacturing cost are used as evaluation indices in optimization, it is sufficient if a parameter set that can reduce the electric power consumption and the manufacturing cost as much as possible within such a range that a condition that the image recognition reliability is kept equal to or higher than a certain value is satisfied is searched for.

### <3. Third Embodiment>

A third embodiment is an approach example for attempting to enhance the robustness of image recognition against differences between types of subjects in a case where the analysis process executing section AP performs, as an image recognition process, class identification described before.

FIG. 11 is a figure for explaining a parameter optimization approach as the third embodiment.

As depicted in the figure, the optimization system 100 in this case is different from that in the first embodiment in that the optimization system 100 is provided with an optimization processing section F1C instead of the optimization processing section F1.

In addition, as a premise here, the analysis process executing section AP performs, as the AI image recognition process, the class identification process described before.

Here, in a case where, for example, particular target classes such as "human" or "dog" are identified as class identification, the precision of the class identification varies in some cases depending on types of subjects belonging to the target classes. The figure depicts a case where there are a white dog (type 1), a black dog (type 2), a dog with black spots on a white base color (type 3), and the like as types of subjects belonging to the target class = "dog," and, for example, in this case, the precision of the class identification process regarding the target class = "dog" can vary depending on the types of dogs.

The analysis process executing section AP in this case computes an image recognition reliability for each type of subject of the target class in the AI image recognition process performed as the class identification. At this time, it is possible that information regarding the types of subjects in the target class is included in subject information input to the sensing device simulator SS and is output to the analysis process executing section AP as accompanying information regarding image data generated by the sensing device simulator SS.

On the basis of the image recognition reliability of each type of subject, the optimization processing section F1C performs a process of searching for a parameter set that makes variations of the image recognition reliability of each type of subject equal to or smaller than a certain value.

Specifically, the optimization processing section F1C performs a process of searching for a parameter set that satisfies a condition that the image recognition reliability of each type of subject is made equal to or greater than a predetermined value and the amounts of error between the image recognition reliabilities of the types of subjects are made equal to or smaller than a certain value.

For example, as a possible process, a parameter set that satisfies a condition that the maximum error between the image recognition reliabilities of the types of subjects is made equal to or smaller than 5% and all the values of the image recognition reliabilities of the types of subjects are made 60% can be searched for.

By adopting the parameter optimization approach as the third embodiment like the one described above, design optimization of each of the sensing device and the analysis process can be performed such that the robustness of the image recognition process against differences between different types of subjects is enhanced to cope with a case where an image recognition process as class identification targeted at the different types of subjects can be performed.

Note that, also in the third embodiment, parameter optimization may be optimized as a neural network by defining both the sensing parameters and the analysis process parameters such that they can back-propagate in differentiable forms.

In addition, also in the third embodiment, it is possible that the sensing parameters and the analysis process parameters are optimized by different approaches.

### <4. Fourth Embodiment>

In a fourth embodiment, parameter optimization focusing on an area of interest in the image recognition process is performed in a case where the analysis process executing section AP performs an AI image recognition process.

As a premise here, for example, a class identification process on a zebra as a target class like the one depicted in FIG. 12 is performed as the AI image recognition process performed by the analysis process executing section AP.

In the AI image recognition process in this case, an area of interest in the image recognition process is specified for class identification. For example, in a case of the class identification of a zebra, as depicted in the figure, an area including a stripe portion of the zebra is specified as an area of interest.

For example, information regarding the area of interest can be acquired by an approach such as GradCAM.

FIG. 13 is a figure for explaining a parameter optimization approach as the fourth embodiment.

As depicted in the figure, the optimization system 100 in this case is different from that in the first embodiment in that the optimization system 100 is provided with an optimization processing section F1D instead of the optimization processing section F1.

The optimization processing section F1D has an image change amount computing section F11. The optimization processing section F1D estimates the degree of contribution, to an image change in an area of interest, of each of multiple sensing parameters that can be set for the sensing device simulator SS, and performs parameter optimization of, as an update-target parameter, a sensing parameter selected on the basis of the magnitudes of the degrees of contribution.

FIG. 14 is a flowchart depicting a specific processing procedure example in the parameter optimization approach as the fourth embodiment.

The process depicted in this figure is a process performed by the CPU 11 that realizes a function as the optimization processing section F1D.

First, in step S201, the CPU 11 performs a machine learning process of an image recognition AI model.

Specifically, for example, for the image recognition AI model in the analysis process executing section AP, a process is performed for performing machine learning using, as training input data, images generated by the sensing device simulator SS. At this time, for example, it is sufficient if sensing parameters set for the sensing device simulator SS are predetermined parameter such as parameters that have been proven in the past or the like.

By this machine learning process, an area of interest is specified in the image recognition AI model of the analysis process executing section AP.

Note that, in the machine learning process in step S201, it is also possible that, as the training input data, not images generated by the sensing device simulator SS but training image data prepared separately is used.

In step S202 subsequent to step S201, the CPU 11 computes an image change amount of the area of interest in relation to a change of each sensing parameter of multiple sensing parameters. For example, the multiple sensing parameters here mean parameters of items that are classified as sensing parameters such as a parameter related to the pixel count, a parameter related to the spectral characteristics of the color filter S2, a parameter related to the noise value of the fixed noise adding section S5, or the like. In step S202, the CPU 11 computes an image change amount of the area of interest in relation to a change of each sensing parameter of the multiple items. Specifically, a target sensing parameter is changed between two values, and the AI image recognition process by the analysis process executing section AP is executed in a state where each value is set. Then, an image of the area of interest obtained at the analysis process executing section AP in the state where each value is set is acquired, and an image change amount between the images of the area of interest is computed. Such a process of computing an image change amount of the area of interest is performed while the target sensing parameter is modified from one to another.

The process in step S202 is equivalent to the process by the image change amount computing section F11 depicted in FIG. 13.

Note that it is possible that the image change amount is computed as the difference between images (the difference between luminance values), for example.

FIG. 15 depicts figures each for explaining an example of an image change of an area of interest in relation to a change of a sensing parameter.

FIG. 15A illustrates the state of an image change of an area of interest in a case where the target sensing parameter is a parameter related to the pixel count (image resolution) and where the parameter related to the pixel count is changed between two values from a value corresponding to a large pixel count to a value corresponding to a small pixel count.

In addition, FIG. 15B illustrates the state of an image change of the area of interest in a case where the target sensing parameter is a parameter related to the spectral characteristics and where the parameter related to the spectral characteristics is changed between two values from a value corresponding to RGB (color) to a value corresponding to monochrome.

As represented by a comparison between FIG. 15A and FIG. 15B, in a case where a class identification process on a zebra as the target class is performed as in the present example, an image change of the area of interest tends to increase by changing the parameter related to the pixel count, and an image change of the area of interest tends to decrease even if the parameter related to the spectral characteristics is changed.

In FIG. 14, in step S203 subsequent to step S202, the CPU 11 decides a predetermined number of top sensing parameters with the largest image change amounts as optimization target parameters. The optimization target parameters are synonymous with update-target parameters of the parameter optimization process.

In step S204 subsequent to step S203, the CPU 11 performs the optimization process on the sensing parameters and the analysis process parameters as optimization target parameters by using image recognition reliabilities as an evaluation index.

That is, parameters whose degrees of contribution to an image change of the area of interest are low, such as the parameter related to the spectral characteristics described above, are excluded from the update-target parameters in the parameter optimization process.

According to the parameter optimization approach as the fourth embodiment like the one described above, it becomes possible to efficiently reduce the number of update-target parameters in optimization, and it is possible to attempt to enhance the ease of convergence of the optimization process and shorten time required for the optimization process.

In addition, in the parameter optimization approach as the fourth embodiment, it is possible that, for example, parameters excluded from the update-target parameters, such as the parameter related to the spectral characteristics described above, are set to values that result in the most inexpensive sensing device specifications. Specifically, in the example of the parameter related to the spectral characteristics as color/monochrome described above, the parameter related to the spectral characteristics is set to a value corresponding to monochrome that results in more inexpensive sensing device specifications.

Note that, also in the fourth embodiment, parameter optimization may be optimized as a neural network by defining both the sensing parameters and the analysis process parameters such that they can back-propagate in differentiable forms.

In addition, also in the third embodiment, it is possible that the sensing parameters and the analysis process parameters are optimized by different approaches.

### <5. Regarding UI for Optimization>

In the information processing device 1 in the present example, the CPU 11 functions as the optimization processing section F1 (or F1A, F1B, F1C, or F1D) described above, and also functions as a display control section F15 that performs a process of generating display data representing changes of an optimization evaluation index which is an evaluation index used by the optimization processing section for parameter optimization and which is calculated for each parameter set tested in the course of parameter optimization and causing the display section 17 to display the display data (see FIG. 16).

FIG. 17 depicts a specific display example of an optimization evaluation index.

Here, a display screen 17a of the display section 17 displays changes of the optimization evaluation index.

The optimization evaluation index is equivalent to an image recognition reliability described before in a case where the analysis process executing section AP executes an image recognition process, and is equivalent to an amount of sensing error in a case where the analysis process executing section AP executes a process of sensing as in the case depicted in FIG. 7 described earlier. It is also possible that, in a case where multiple evaluation indices such as an image recognition reliability and a device specification evaluation value are used as optimization evaluation indices as in the case depicted in FIG. 9 described earlier, display data representing changes of the multiple evaluation indices are displayed.

It is possible that, as the display data representing changes of an optimization evaluation index as depicted in the figure, data representing, as a graph, an optimization evaluation index calculated for each parameter set tested in the course of parameter optimization is displayed.

Note that the display mode of changes of an optimization evaluation index is not limited to this, and, for example, it is also possible that another display mode such as one in which numerical values are displayed in chronological order is adopted.

By displaying changes of an optimization evaluation index as described above, it is possible to allow a user to grasp whether or not the parameter optimization process is proceeding well toward convergence.

In addition, in the present example, to cope with a case where parameter optimization is performed stepwise separately in multiple steps as in, for example, a case where the genetic algorithm depicted in FIG. 6 is used, the display control section F15 performs a process of generating display data representing changes of an optimization evaluation index of each step and causing the display section 17 to display the display data.

A specific display example is depicted in FIG. 18.

The figure depicts an example in which graphs representing changes of an optimization evaluation index include a graph of the first optimization (the first step of the optimization) represented by a dotted line, a graph of the second optimization represented by a dash-dotted line, and a graph of the current optimization (a step being executed) represented by a solid line. Specifically, the display screen 17a is caused to display display data in which graphs each representing changes of the optimization evaluation index of one step are superimposed one on another.

As a result, it is possible to allow a user to grasp the optimization history of each step. Particularly, by displaying graphs in a superimposed manner, it is possible to attempt to enhance the ease for the user to compare the optimization history of each step.

By being able to grasp the optimization history of each step, the user can modify conditions taking into consideration the influence of an optimization approach of each step, optimization parameters, constraints related to parameters, condition modifications of an input scene, and the like. Moreover, even in a case where the series of optimization is automatically determined by an optimization tool instead of a user, the user can confirm, after completion of the optimization, determinations as to which parameter influence is significant, for example, and there is an advantage that the precision of optimization condition re-setting can be enhanced.

In optimization, it is possible also to adopt an approach in which training according to scenes is added by an approach called reinforcement learning or adopt an approach that is premised on a large number of times of optimization in which a training approach is modified from overall optimization to local optimization. Since, even in such a procedure, it is preferable that the optimization history of each step can be grasped, a function that makes it possible to display optimization results of each step in a superimposed manner is preferable.

In addition, also regarding an index different from an optimization evaluation index (i.e., another index not used as an evaluation index in parameter optimization), the display control section F15 in the present example performs a process of generating display data representing changes of values calculated for each parameter set tested in the course of parameter optimization and causing the display section 17 to display the display data on the display screen 17a.

FIG. 18 depicts an example in which graphs representing changes of the electric power consumption of a sensing device as the other index are displayed on the display screen 17a along with the graphs representing changes of the optimization evaluation index.

Parameter optimization is executed according to a desired cost function, and, since a product designer needs to also grasp, in order to realize desired product specifications, the tendency of an index which represents another feature, it is desirable that multiple indices be displayed as described above. Typically, in functions of a camera that captures images of subjects, a function related to the contrast performance and a function related to the image resolution performance are conflicting functions, and are in a relation in which, if one is made better, the other worsens. For example, there are no problems if performance is one that can be grasped logically and empirically in such a manner, but, in a case where parameters which are conventionally not intended are optimized while multiple indices are being optimized, it is preferable that changes of multiple important indices be always grasped in a situation where foresight knowledge like ones described before cannot be obtained. In view of this, as a screen function, information representing how other performance not designated as an optimization evaluation index is changing during the optimization or information representing to which value other performance not designated as an optimization evaluation index has converged after the optimization is displayed as depicted in FIG. 18. As a result, the designer can simply grasp the status of the series of optimization efficiently.

### <6. Regarding Application Example of Present Technology>

### (6-1. System on Which Application Example Is Premised)

There can be various application examples of the present technology, and an example is explained here.

First, the configuration and functions of an information processing system 30 on which the present application example is premised are explained with reference to FIG. 19 to FIG. 26.

FIG. 19 is a block diagram depicting a schematic configuration example of the information processing system 30 as an embodiment according to the present technology.

As depicted in the figure, the information processing system 30 includes at least a cloud server 31, a user terminal 32, multiple cameras 33, a fog server 34, and a management server 35. In the present example, at least the cloud server 31, the user terminal 32, the fog server 34, and the management server 35 are configured to be capable of mutual communication via a network 36 such as the Internet, for example.

The cloud server 31, the user terminal 32, the fog server 34, and the management server 35 are each configured as an information processing device including a microcomputer having a CPU (Central Processing Unit), a ROM (Read Only Memory), and a RAM (Random Access Memory).

Here, the user terminal 32 is an information processing device that may be used by a user who is a recipient of a service using the information processing system 30. In addition, the management server 35 is an information processing device that may be used by a provider of a service.

For example, each camera 33 includes an image sensor such as a CCD (Charge Coupled Device) type image sensor or a CMOS (Complementary Metal Oxide Semiconductor) type image sensor, captures images of subjects, and obtains image data (captured image data) as digital data. In addition, as described later, each camera 33 also functions to perform a process using AI (Artificial Intelligence) (e.g., an image recognition process, an image sensing process, etc.) on captured images. In the following explanation, various types of processes on images such as an image recognition process or an image sensing process are described simply as "image processing." For example, various types of processes on images using AI (or an AI model) are described as "AI image processing."

Each camera 33 is configured to be capable of data communication with the fog server 34, and, for example, is made capable of transmitting, to the fog server 34, various types of data such as processing result information representing results of processes (image processing, etc.) using AI, receiving various types of data from the fog server 34, and so on.

Here, for example, use of the information processing system 30 depicted in FIG. 19 may include one in which, on the basis of processing result information obtained by image processing performed by each camera 33, the fog server 34 or the cloud server 31 generates analytical information regarding subjects and a user is allowed to view the generated analytical information via the user terminal 32.

In this case, possible use of each camera 33 includes use of various types of monitoring cameras. For example, possible examples of the use include use of monitoring cameras for indoor spaces such as stores, offices, or houses, monitoring cameras (including traffic monitoring cameras and the like) for monitoring outdoor spaces at parking lots, in town, and so on, monitoring cameras of manufacturing lines in FA (Factory Automation) or IA (Industrial Automation), monitoring cameras that monitor the insides of vehicles or the outsides of vehicles, and the like.

For example, it is possible that, in a case of the use of monitoring cameras in a store, each of the multiple cameras 33 is arranged at a predetermined position in the store to allow a user to check customer segments of in-store customers (genders, age brackets, etc.), behaviors of in-store customers in the store (the lines of flow), and the like. In that case, it is possible that, as the analytical information described above, information regarding the customer segments of the in-store customers, information regarding the lines of flow of in-store customers in the store, information regarding the congestion state at payment cash registers (e.g., waiting time of the payment cash registers), and the like are generated.

Alternatively, in a case of the use of traffic monitoring cameras, it is possible that each camera 33 is arranged at a position near a road to allow a user to recognize information such as the number (vehicle number), vehicle color, or vehicle model of a passing vehicle. In that case, it is possible that, as the analytical information described above, information such as the number, the vehicle color, or the vehicle model is generated.

In addition, in a case where traffic monitoring cameras are used in a parking lot, it is possible that the cameras are arranged such that they can monitor each parked vehicle, monitor whether there is a suspicious person who is showing a suspicious behavior around each vehicle, and so on, and, in a case where there is a suspicious person, notifies that there is a suspicious person, or make a notification of the attribute (gender, age bracket) of the suspicious person, for example.

Further, it is also possible that available spaces in town or a parking lot are monitored to notify a user of the location of a space where she/he can park her/his vehicle.

For example, in a case of the use for monitoring of stores described above, the fog server 34 may be arranged for each monitoring target by, for example, being arranged in a monitoring-target store along with each camera 33. By providing the fog server 34 for each monitoring target such as a store in such a manner, it becomes unnecessary for the cloud server 31 to directly receive transmission data from the multiple cameras 33 at the monitoring targets, and it is possible to attempt to reduce the processing load of the cloud server 31.

Note that it is also possible that, in a case where there are multiple monitoring-target stores and all the stores are stores belonging to the same chain, the fog server 34 is not provided for each store but provided singly for the multiple stores. That is, the fog server 34 is not necessarily provided for each monitoring target, and can be provided singly for multiple monitoring targets.

Note that, in a case where the cloud server 31 or each camera 33 can function as the fog server 34 for such reasons as that the cloud server 31 or each camera 33 has processing power, the fog server 34 may be omitted from the information processing system 30, each camera 33 may be connected directly to the network 36, and transmission data from the multiple cameras 33 may be received directly by the cloud server 31.

Various types of devices described above can be roughly classified into cloud-side information processing devices and edge-side information processing devices in the following explanation.

The cloud server 31 and the management server 35 fall under the cloud-side information processing devices, and the cloud-side information processing devices are a device group that provides services that may be used by multiple users.

In addition, the cameras 33 and the fog server 34 fall under the edge-side information processing devices, and the edge-side information processing devices can be understood as a device group arranged in an environment prepared by a user who uses a cloud service.

It should be noted that both the cloud-side information processing devices and the edge-side information processing devices may be in an environment prepared by the same user.

Note that the fog server 34 may be an on-premises server.

Registration of an AI model and an AI application in the information processing system 30 is explained with reference to FIG. 20 to FIG. 22.

As described above, in the information processing system 30, the cameras 33, which are edge-side information processing devices, perform AI image processing, and the cloud server 31, which is a cloud-side information processing device, realizes an advanced application function by using information regarding results of the edge-side AI image processing (e.g., result information regarding image recognition processes using AI).

Here, there are various possible types of approaches to registering an application function in the cloud server 31 (or including the fog server 34), which is a cloud-side information processing device.

An example thereof is explained with reference to FIG. 20.

Note that, although illustration of the fog server 34 is omitted in FIG. 20, a configuration including the fog server 34 may be adopted. The fog server 34 at that time may bear some of edge-side functions.

The cloud server 31 and the management server 35 described above are information processing devices included in the cloud-side environment.

In addition, the cameras 33 are information processing devices included in the edge-side environment.

Note that the cameras 33 can be understood as being devices including control sections that perform overall control of the cameras 33, and the cameras 33 can be understood as being devices including other devices as image sensors IS including computation processing sections that perform various types of processes including AI image processing on captured images. That is, the cameras 33, which are edge-side information processing devices, may be understood as having, mounted therein, the image sensors IS, which are other edge-side information processing devices.

In addition, the user terminal 32 to be used by a user who uses various types of services provided by a cloud-side information processing device includes an application developer terminal 32A used by a user who develops an application used for AI image processing, an application user terminal 32B used by a user who uses an application, an AI model developer terminal 32C used by a user who develops an AI model used for AI image processing, and the like.

Note that, needless to say, the application developer terminal 32A may be used by a user who develops an application that does not use AI image processing.

On a cloud-side information processing device, training datasets for performing training of AI have been prepared. A user who develops an AI model communicates with the cloud-side information processing device by using the AI model developer terminal 32C, and downloads the training datasets. At this time, the training datasets may be provided for a fee. For example, an AI model developer may register personal information in a marketplace (electronic market) prepared as a cloud-side function, thereby making it possible for her/him to purchase various types of functions or materials registered in the marketplace and purchase the training datasets.

After developing an AI model by using the training datasets, the AI model developer registers, in the marketplace, the AI model having been developed, by using the AI model developer terminal 32C. As a result, it may be made possible for the AI model developer to be paid an incentive when the AI model is downloaded.

In addition, a user who develops an application downloads an AI model from the marketplace by using the application developer terminal 32A, and develops an application that uses the AI model (hereinafter, described as an "AI application"). At this time, as described before, the AI model developer may be paid an incentive.

By using the application developer terminal 32A, the application development user registers, in the marketplace, the AI application having been developed. As a result, it may be made possible for the user who has developed the AI application to be paid an incentive when the AI application is downloaded.

By using the application user terminal 32B, a user who uses an AI application performs operation for deploying an AI application and an AI model from the marketplace to a camera 33 as an edge-side information processing device managed by her/himself. At this time, it may be made possible for an AI model developer to be paid an incentive.

As a result, it becomes possible for the camera 33 to perform AI image processing using the AI application and the AI model, and it becomes possible for the camera 33 to not only capture images but sense in-store customers or sense vehicles by the AI image processing.

Here, the deployment of the AI application and the AI model means installation of the AI application and the AI model onto a target (device) as an executing section such that the target as the executing section can use the AI application and the AI model, stated differently, such that the target as the executing section can execute at least some programs as the AI application.

In addition, it may be made possible for the camera 33 to extract, by the AI image processing, attribute information regarding in-store customers from captured images captured at the camera 33.

The attribute information is transmitted from the camera 33 to a cloud-side information processing device via the network 36.

Cloud applications have been deployed to the cloud-side information processing device, and it has been made possible for each user to use the cloud applications via the network 36. Further, applications that analyze the lines of flow of in-store customers by using attribute information regarding the in-store customers or captured images, for example, have been prepared in the cloud applications. Such cloud applications are uploaded by an application development user or the like.

It has been made possible for an application user to analyze the lines of flow of in-store customers of her/his store and view analysis results by using the application user terminal 32B to use a cloud application for line-of-flow analysis. For example, the analysis results are viewed as the lines of flow of the in-store customers that are graphically presented on a map of the store.

In addition, the analysis results may be viewed as, for example, the density of the in-store customers which is presented as results of line-of-flow analysis displayed in the form of a heat map.

In addition, these pieces of information may be displayed in such a manner that they are sorted by attribute information regarding the in-store customers.

On the cloud-side marketplace, an AI model optimized for each user may be registered. For example, captured images captured at a camera 33 arranged in a store managed by a user are uploaded to and accumulated in a cloud-side information processing device as appropriate.

The cloud information processing device executes a process of performing a retraining process of an AI model, updating the AI model, and re-registering the AI model in the marketplace every time the number of uploaded and accumulated captured images reaches a certain number.

Note that, for example, a user may be allowed to select the retraining process of the AI model as an option on the marketplace.

For example, it is possible to enhance the recognition rate and the like of image processing on captured images captured at a dark location, by deploying, to a camera 33 arranged in a store, an AI model retrained using dark images from the camera 33. In addition, it is possible to enhance the recognition rate and the like of image processing on images captured at a bright location, by deploying, to a camera 33 arranged outside a store, an AI model retrained using bright images from the camera 33.

That is, it becomes possible for an application user to always obtain optimized processing result information by re-deploying an updated AI model to the camera 33.

Note that the retraining process of an AI model is described later on.

In addition, in a case where personal information is included in information (captured images, etc.) uploaded from the camera 33 to a cloud-side information processing device, from the perspective of protection of privacy, data from which information related to privacy is deleted may be uploaded, or data from which the information related to privacy is deleted may be made available to an AI model development user or an application development user.

The processing procedure described above is depicted as flowcharts in FIG. 21 and FIG. 22.

Note that the cloud server 31, the management server 35, and the like in FIG. 19 fall under cloud-side information processing devices.

When an AI model developer views a list of datasets registered in a marketplace by using the AI model developer terminal 32C having a display section including an LCD (Liquid Crystal Display), an organic EL (Electro Luminescence) panel, or the like and selects a desired dataset, in step S401, the AI model developer terminal 32C transmits a request for downloading the selected dataset to a cloud-side information processing device.

In response to this, in step S301, the cloud-side information processing device accepts the request, and, in step S302, performs a process of transmitting the requested dataset to the AI model developer terminal 32C.

In step S402, the AI model developer terminal 32C performs a process of receiving the dataset. As a result, it becomes possible for the AI model developer to develop an AI model using the dataset.

When, after the AI model developer finishes developing the AI model, the AI model developer performs operation of registering, in the marketplace, the AI model having been developed (e.g., designating the name of the AI model, the address where the AI model is placed, and the like), in step S403, the AI model developer terminal 32C transmits a request for registering the AI model in the marketplace to the cloud-side information processing device.

In response to this, in step S303, the cloud-side information processing device accepts the registration request, and, for example, can cause the AI model to be displayed on the marketplace by performing a process of registering the AI model in step S304. As a result, it becomes possible for users other than the AI model developer to download the AI model from the marketplace.

For example, an application developer who intends to develop an AI application views a list of AI models registered in the marketplace by using the application developer terminal 32A. In step S501, according to operation by the application developer (e.g., operation of selecting one of AI models on the marketplace), the application developer terminal 32A transmits a request for downloading the selected AI model to the cloud-side information processing device.

In step S305, the cloud-side information processing device accepts the request, and, in step S306, transmits the AI model to the application developer terminal 32A.

In step S502, the application developer terminal 32A receives the AI model. As a result, it becomes possible for the application developer to develop the AI application using the AI model developed by another person.

When, after the application developer finishes developing the AI application, the application developer performs operation for registering the AI application in the marketplace (e.g., operation of designating the name of the AI application, the address where the AI model is placed, and the like), in step S503, the application developer terminal 32A transmits a request for registering the AI application to the cloud-side information processing device.

In step S307, the cloud-side information processing device accepts the registration request, and, for example, can cause the AI application to be displayed on the marketplace by performing registration of the AI application in step S308. As a result, it becomes possible for users other than the application developer to select the AI application on the marketplace and download the AI application.

For example, as depicted in FIG. 22, in step S601, a user who is trying to use an AI application performs purpose selection by using the application user terminal 32B. In the purpose selection, a selected purpose is transmitted to the cloud-side information processing device.

In response to this, in step S309, the cloud-side information processing device selects an AI application according to the purpose, and, in step S310, performs a preparation process (deployment preparation process) for deploying an AI application or an AI model to each device.

In the deployment preparation process, according to information regarding a target device of a deployment process of an AI model or an AI application, for example, information regarding the camera 33 or the fog server 34, performance requested by the user, or the like, an AI model is decided, for example.

In addition, in the deployment preparation process, it is decided which device is caused to execute each SW (Software) component included in an AI application for realizing a function desired by the user, on the basis of performance information regarding each device or information regarding a request from the user.

Each SW component may be a container described later, or may be a microservice. Note that it is possible to realize SW components with use of a WebAssembly technology.

An AI application that counts the number of in-store customers with each attribute such as gender or age includes an SW component that senses the faces of humans from a captured image with use of an AI model, an SW component that extracts attribute information regarding the humans from face sensing results, an SW component that tabulates results, an SW component that visualizes tabulation results, and the like.

In step S311, the cloud-side information processing device performs a process of deploying each SW component to each device. In this process, an AI application and a AI model are transmitted to each device such as the camera 33.

In response to this, in step S701, the camera 33 performs a process of deploying the AI application and the AI model. As a result, it becomes possible to perform AI image processing on captured images captured at the camera 33.

Note that, although not depicted in FIG. 22, the fog server 34 also similarly performs a process of deploying the AI application and the AI model as necessary.

Note that, in a case where the camera 33 executes all the processes, the process of deployment to the fog server 34 is not performed.

In step S702, the camera 33 acquires an image by performing an image-capturing operation. Then, in step S703, the camera 33 performs AI image processing on the acquired image, and obtains image recognition results, for example.

In step S704, the camera 33 performs a process of transmitting the captured image or information regarding results of the AI image processing. In the information transmission in step S704, both the captured image and the information regarding results of the AI image processing may be transmitted, or only either of them may be transmitted.

In step S312, the cloud-side information processing device having received these pieces of information performs an analysis process. By this analysis process, for example, analysis of the lines of flow of in-store customers, a vehicle analysis process for traffic monitoring, or the like is performed.

In step S313, the cloud-side information processing device performs a process of presenting analysis results. For example, this process is realized by the user using the cloud application described above.

Upon the process of presenting the analysis results, in step S602, the application user terminal 32B performs a process of causing a monitor or the like to display the analysis results.

With the processes up to this point, the user who is a user of the AI application can obtain analysis results according to the purpose selected in step S601.

Note that the cloud-side information processing device may update the AI model after step S313. By updating and deploying the AI model, it becomes possible to obtain analysis results suited for a use environment of the user.

Here, after the SW components of the AI application and the AI model are deployed to the side of the camera 33, by being triggered by operation by a provider of a service or a user, the information processing system 30 can retrain the AI model and update the AI model (hereinafter, described as an "edge-side AI model") and the AI application deployed to the side of each camera 33.

The procedure of a specific process is explained with reference to FIG. 23. Note that FIG. 23 is drawn focusing on one camera 33 among the multiple cameras 33. In addition, whereas, as an example, an update-target edge-side AI model is one that has been deployed to the image sensor IS included in the camera 33 in the following explanation, needless to say, the edge-side AI model may be one that has been deployed outside the image sensor IS of the camera 33.

First, in processing step PS1, an AI model retraining instruction from a provider or a user of a service is given. This instruction is given using an API function included in an API (Application Programming Interface) module included in a cloud-side information processing device. In addition, the instruction designates the amount of images (e.g., the number of images) to be used for training. Hereinafter, the amount of images to be used for training is described also as a "predetermined number of images."

Upon receiving the instruction, in processing step PS2, the API module transmits, to a Hub (similar to the one depicted in FIG. 5), a request for retraining and information regarding the amount of images.

In processing step PS3, the Hub transmits an update notification and information regarding the amount of images to the camera 33 as an edge-side information processing device.

In processing step PS4, the camera 33 transmits captured image data obtained by performing image capturing to an image DB (Database) of a storage group. This image-capturing process and the transmission process are performed until the predetermined number of images necessary for the retraining is reached.

Note that, in a case where the camera 33 has obtained inference results by performing an inference process on the captured image data, in processing step PS4, the camera 33 may store, on the image DB, the inference results as metadata of the captured image data.

By storing the results of the inference at the camera 33 as metadata on the image DB, it is possible to carefully select data necessary for the retraining of the AI model to be executed on the cloud side. Specifically, the retraining can be performed using only image data for which results of the inference at the camera 33 and results of inference executed using abundant computer resources at the cloud-side information processing device are different. Accordingly, it becomes possible to shorten time required for the retraining.

After the image capturing and transmission of the predetermined number of images are ended, in processing step PS5, the camera 33 notifies the Hub that the transmission of data of the predetermined number of captured images has been completed.

Upon receiving the notification, in processing step PS6, the Hub notifies an orchestration tool that preparation of data for the retraining has been completed.

In processing step PS7, the orchestration tool transmits an instruction for executing a labeling process to a labeling module.

The labeling module acquires, from the image DB, target image data of the labeling process (processing step PS8), and performs the labeling process.

The labeling process here may be a process of performing the class identification described above, may be a process of estimating the gender or age of a subject in an image and giving a label, may be a process of estimating a pose which a subject is in and giving a label, or may be a process of estimating a behavior of a subject and giving a label.

The labeling process may be performed manually, or may be performed automatically. In addition, the labeling process may conclude on the cloud-side information processing device, or may be realized by use of a service provided by another server device.

In processing step PS9, the labeling module having ended the labeling process stores, on a dataset DB, information regarding results of the labelling. The information stored on the dataset DB here may be a set of labelled information and image data, or may be image ID (Identification) information for identifying image data, instead of the image data itself.

In processing step PS10, a storage managing section having sensed that the information regarding results of the labelling has been stored notifies the orchestration tool.

The orchestration tool having received the notification confirms that the labeling process of the data of the predetermined number of images has been ended, and, in processing step PS11, transmits a retraining instruction to the retraining module.

In processing step PS12, the retraining module having received the retraining instruction acquires datasets to be used for training from the dataset DB, and, in processing step PS13, acquires an update-target AI model from a trained AI model DB.

The retraining module performs retraining of the AI model by using the acquired datasets and the AI model. In processing step PS14, the thus-obtained updated AI model is re-stored on the trained AI model DB.

In processing step PS15, the storage managing section having sensed that the updated AI model has been stored notifies the orchestration tool.

In processing step S16, the orchestration tool having received the notification transmits an AI model conversion instruction to a conversion module.

In processing step PS17, the conversion module having received the conversion instruction acquires the updated AI model from the trained AI model DB, and performs an AI model conversion process.

In the conversion process, a process of conversion according to specification information or the like regarding the camera 33 which is deployment-destination equipment is performed. In this process, downsizing is performed while lowering of the performance of the AI model is avoided as much as possible, and conversion of the file format or the like is performed such that the AI model can operate on the camera 33.

The conversion module makes the converted AI model the edge-side AI model described above. In processing step PS18, the converted AI model is stored on a converted AI model DB.

In processing step PS19, the storage managing section having sensed that the converted AI model has been stored notifies the orchestration tool.

In processing step PS20, the orchestration tool having received the notification transmits, to the Hub, a notification for executing updating of the AI model. This notification includes information for identifying a location where the AI model to be used for the updating is stored.

The Hub having received the notification transmits an AI model update instruction to the camera 33. The update instruction also includes information for identifying the location where the AI model is stored.

In processing step PS22, the camera 33 performs a process of acquiring and deploying the target converted AI model from the converted AI model DB. As a result, the AI model used at the image sensor IS of the camera 33 is updated.

In processing step PS23, the camera 33 for which the updating of the AI model has been ended with the deployment of the AI model transmits an update completion notification to the Hub.

In processing step PS24, the Hub having received the notification notifies the orchestration tool that the AI model updating process of the camera 33 has been completed.

Note that, whereas the AI model is deployed to and used in the image sensor IS of the camera 33 in the example explained here, the AI model can be updated similarly even in a case where the AI model is deployed to and used in a memory outside the image sensor in the camera 33 or in the fog server 34.

In that case, when the AI model is deployed, a device (location) where the AI model is deployed is stored in advance on a cloud-side storage managing section or the like, and the Hub reads out, from the storage managing section, the device (location) where the AI model is deployed, and transmits an AI model update instruction to the device where the AI model is deployed.

In processing step PS22, the device having received the update instruction performs a process of acquiring and deploying the target converted AI model from the converted AI model DB. As a result, the AI model of the device having received the update instruction is updated.

Note that, in a case where only updating of the AI model is performed, the processes up to this point conclude with this updating.

In a case where updating of an AI application using the AI model is to be performed in addition to the updating of the AI model, a process depicted below is further executed.

Specifically, in processing step PS25, the orchestration tool transmits, to a deployment control module, an instruction for downloading an AI application such as updated firmware.

In processing step PS26, the deployment control module transmits an AI application deployment instruction to the Hub. This instruction includes information for identifying a location where the updated AI application is stored.

In processing step PS27, the Hub transmits the deployment instruction to the camera 33.

In processing step PS28, the camera 33 downloads and deploys the updated AI application from a container DB of the deployment control module.

Note that the updating of the AI model operating on the image sensor IS of the camera 33, and the updating of the AI application operating outside the image sensor IS in the camera 33 are performed sequentially in the example explained in the description above.

In addition, whereas the AI application is explained here for simplification of explanation, as described before, the AI application is defined by multiple SW components such as SW components B1, B2, B3, ..., and Bn, information regarding the location where each SW component is deployed is stored in advance on the cloud-side storage managing section or the like when the AI application is deployed, and the Hub reads out the device (location) where each SW component is deployed, from the storage managing section when the Hub performs the process in processing step PS27, and transmits a deployment instruction to the device where the SW component is deployed. In processing step PS28, the device having received the deployment instruction downloads and deploys the updated SW components from the container DB of the deployment control module.

Note that the AI application described here is SW components other than the AI model.

In addition, in a case where both the AI model and the AI application operate on one device, both the AI model and the AI application may be updated collectively as one container. In that case, updating of the AI model and updating of the AI application may be performed not sequentially but simultaneously. Further, it is possible to realize the updating by executing the processes of processing steps PS25, PS26, PS27, and PS28.

For example, in a case where the container of both the AI model and the AI application can be deployed to the image sensor IS of the camera 33, the updating of the AI model and the AI application can be performed by executing the processes of processing steps PS25, PS26, PS27, and PS28 as described above.

By performing the processes described above, retraining of an AI model is performed using data of captured images captured in a use environment of a user. Accordingly, an edge-side AI model that can output highly precise recognition results in the use environment of the user can be generated.

In addition, even if a use environment of a user has changed in a case where the layout in a shop has been modified, the installation location of the camera 33 has been modified, or in other cases, retraining of an AI model can be performed appropriately in each occasion, and accordingly, it becomes possible to keep the recognition precision of the AI model without deterioration.

Note that each process described above may be executed not only at the time of retraining of an AI model, but also when a system is activated for the first time in a use environment of a user.

AI models can be registered in a marketplace as described before, and a user of the camera 33 (a user of AI models) can purchase a desired AI model at the marketplace.

Examples of screens that is related to the marketplace and presented to users are explained with reference to FIG. 24 to FIG. 26.

FIG. 24 depicts an example of a login screen G1.

The login screen G1 is provided with an ID input field 91 for inputting a user ID (login ID) and a password input field 92 for inputting a password.

A login button 93 for logging in and a cancel button 94 for cancelling logging in are arranged below the password input field 92.

In addition, further below them, a control element for transitioning to a page for a user who has forgotten the password, a control element for transitioning to a page for new user registration, and the like are arranged as appropriate.

When the login button 93 is pressed after an appropriate user ID and password are input, a process of transitioning to a user-specific page is executed at each of the cloud server 31 and a user terminal 32.

For example, FIG. 25 depicts an example of a screen presented to an AI application developer who uses the application developer terminal 32A or an AI model developer who uses the AI model developer terminal 32C.

It is made possible for each developer to purchase, for development, a training dataset, an AI model, and an AI application through the marketplace. In addition, it is made possible to register, in the marketplace, AI applications or AI models developed by the developers themselves.

On a developer screen G2 depicted in FIG. 25, training datasets, AI models, AI applications, and the like (hereinafter, described as "data" collectively) that can be purchased are displayed on the left side.

Note that, although not depicted, when a training dataset is to be purchased, an image of the training dataset is displayed on the display, and preparation for training can be completed simply by surrounding, with a frame by use of an input device such as a mouse, only a desired portion of the image and inputting a name.

For example, in a case where it is desired to perform AI training using an image of a cat, an image to which an annotation, cat, is added can be prepared for AI training simply by surrounding, with a frame, a portion of a cat on an image and inputting "cat" as a text input.

In addition, it may be made possible to select a purpose such as "traffic monitoring," "line-of-flow analysis," or "in-store customer count" such that desired data can be found easily. That is, a display process in which only data matching a selected purpose is displayed is executed at each of the cloud server 31 and the user terminal 32.

Note that the developer screen G2 may display a purchase price of each piece of data.

In addition, the right side of the developer screen G2 is provided with input fields 95 for registering a training dataset collected or created by a developer and an AI model and an AI application developed by a developer.

For each piece of data, input fields 95 for inputting its name and the storage location of the data are provided. In addition, for an AI model, a check box 96 for setting whether retraining is necessary/unnecessary is provided.

Note that price setting fields (illustrated as input fields 95 in the figure), for example, in which purchase prices of registration-target data can be set may be provided.

In addition, at the top section of the developer screen G2, a user name, the date of last login, and the like are displayed as part of user information. Note that, other than these, a currency amount, points, and the like that the user can use at the time of data purchase may be displayed.

For example, FIG. 26 depicts an example of a user screen G3 presented to a user (the application user described above) who performs various types of analysis or the like, by deploying an AI application or an AI model to the camera 33 as an edge-side information processing device managed by the user her/himself.

It is made possible for the user to purchase, via the marketplace, the camera 33 to be arranged in a monitoring-target space. Accordingly, on the left side of the user screen G3, radio buttons 97 by which the type or performance of the image sensor IS mounted on the camera 33, the performance of the camera 33, and the like can be selected are arranged.

In addition, it is made possible for the user to purchase, via the marketplace, an information processing device as the fog server 34. Accordingly, on the left side of the user screen G3, radio buttons 97 for selecting respective types of performance of the fog server 34 are arranged.

In addition, a user who already has a fog server 34 can register the performance of the fog server 34 by inputting here performance information regarding the fog server 34.

The user realizes a desired function by installing a purchased camera 33 (which may be a camera 33 purchased not via the marketplace) at a certain location such as a store run by her/himself, and it is made possible, on the marketplace, to register information regarding an installation location of the camera 33 in order to get the best from the functions of each camera 33.

Radio buttons 98 by which environment information regarding an environment where the camera 33 is to be installed can be selected are arranged on the right side of the user screen G3. When the user selects appropriate environment information regarding an environment where the camera 33 is to be installed, optimum image-capturing settings described above are set for the target camera 33.

Note that, in a case where an installation location of the camera 33 that is planned to purchase has been determined at the time of purchase of the camera 33, by selection of each item on the left side and each item on the right side on the user screen G3, the camera 33 for which image-capturing settings that are optimum for the planned installation location are preset can be purchased.

An execute button 99 is provided on the user screen G3. When the execute button 99 is pressed, the screen transitions to a confirmation screen for confirming the purchase, or a confirmation screen for confirming environment information settings. As a result, it is made possible for the user to purchase a desired camera 33 or fog server 34 or set environment information regarding the camera 33.

It is made possible, on the marketplace, to modify environment information regarding each camera 33 in preparation for times when the installation location of the camera 33 is modified. By re-inputting environment information regarding the installation location of the camera 33 on a modification screen, which is not depicted, it becomes possible to reset image-capturing settings optimum for the camera 33.

### (6-2. Application Example)

Here, it is possible that a parameter optimization approach according to the present technology is applied to a server device, such as the cloud server 31 explained in the description above, managed by a service operator providing AI model deployment services.

At this time, it is possible that sensing parameters are limited to those that can be reproduced by a transmission-type optical filter attached to the lens section of the camera 33 and that design optimization of the sensing device is performed as design optimization of this optical filter.

A server device (hereinafter, described as a "server device 50") managed by a service operator of the cloud server 31 or the like performs a parameter optimization process by a parameter optimization approach as the embodiments explained in the description above on parameters (analysis process parameters) of an AI model that should be deployed to the camera 33 and parameters (sensing parameters) of the optical filter described above.

For example, in an image recognition process using the AI model, it is known that the image recognition performance changes due to seasonal changes (what are generally called drifts of the AI characteristics), and it is possible that the server device 50 performs an optimization process on the parameters of the AI model and the parameters of the optical filter described above, by a parameter optimization approach as an embodiment, for example, every season.

At this time, the server device 50 deploys, to the target camera 33, the AI model for which the analysis process parameters determined in the optimization process have been set. In addition, along with this, the service operator provides, to a user of the target camera 33, the above-described optical filter designed according to the sensing parameters determined in the optimization process, and allows the user to attach the optical filter to the camera 33.

As a result, it is possible to attempt to make it possible to keep the AI performance of the camera 33 at certain favorable performance against the AI drifts.

At this time, at the target camera 33, it is possible that a display section is caused to display message information suggesting replacement of the optical filter or updating of the AI model, such as "please attach a designated optical filter," or "please update the AI model," for example, when a timing at which optimization of the parameters should be executed has come, for example, every season or at other timings.

### <7. Modification Examples>

Note that embodiments are not limited to the specific examples described above, and can adopt diverse configurations as modification examples.

For example, the sensing device is an image capturing device in the examples in the description above, and, in this case, subject information may be updated in the course of parameter optimization.

In addition, whereas, for example, evaluation result information regarding an analysis process as image recognition reliabilities, amounts of sensing error, and the like, and device specification evaluation values (see the second embodiment) have been illustrated as examples of optimization evaluation indices in the description above, it is also possible that, as optimization evaluation indices, for example, specification evaluation values of the analysis process executing section AP (the execution speed and consumed memory amount of an analysis process by the analysis process executing section AP, a neural network size in a case where an AI model is used, etc.) are used.

In addition, whereas different information processing devices have the analysis process executing section AP, the sensing device simulator SS, and the optimization processing section F1 (or F1A, F1B, F1C, or F1D) in configurations illustrated in the description above, it is also possible that an information processing device that has the optimization processing section F1 has either of or both the analysis process executing section AP and the sensing device simulator SS.

In addition, whereas, to cope with a case where the analysis process executing section AP performs an image analysis process, the sensing device simulator SS is configured as an image capturing device simulator in the examples described in the description above, the sensing device simulator SS is not limited to an image capturing device simulator in the present technology. For example, it is also possible that, to cope with a case where the analysis process executing section AP performs a sound analysis process, a microphone simulator is used as the sensing device simulator SS and so on, and, in the present technology, the sensing device simulator SS can also be configured as a simulator of another sensing device other than an image capturing device.

### <8. Program>

As an embodiment, it is possible that a program causes, for example, a CPU, a DSP (Digital Signal Processor), or the like or a device including any of these, to realize the functions of the optimization processing sections F1, F1A, F1B, F1C, and F1D explained with reference to FIG. 5, FIG. 10, FIG. 14, and the like described earlier.

That is, a program according to an embodiment is a program that can be read by a computer device and causes the computer device to realize a function to update and optimize set parameters of a sensing device simulator that estimates, on the basis of the parameters, sensing data obtained by a sensing device and update and optimize set parameters of an analysis process executing section that performs, on the basis of the parameters, an analysis process on the sensing data, on the basis of evaluation results of the analysis process performed by the analysis process executing section using, as an input, the sensing data estimated by the sensing device simulator.

With such a program, the functions of the optimization processing section F1 and the like described above can be realized in equipment as the information processing device 1 or the like.

Such a program as described above can be recorded in advance on a HDD (Hard Disc Drive) as a recording medium built in equipment such as a computer device, a ROM in a microcomputer having a CPU, or the like.

Alternatively, it is also possible to temporarily or permanently store (record) the program on a removable recording medium such as a flexible disc, a CD-ROM (Compact Disc Read Only Memory), an MO (Magneto Optical) disc, a DVD (Digital Versatile Disc), a Blu-ray Disc (registered trademark), a magnetic disc, a semiconductor memory, or a memory card. Such a removable recording medium can be provided as what is generally called package software.

Further, in addition to being installed from a removable recording medium to a personal computer or the like, such a program can also be downloaded from a download site via a network such as a LAN (Local Area Network) or the Internet.

In addition, such a program is suited for widely providing parameter optimization approaches as embodiments. For example, by downloading the program onto personal computers, portable information processing devices, mobile phones, game machines, video equipment, PDAs (Personal Digital Assistants), and the like, it is possible to cause those personal computers and the like to function as devices that realize parameter optimization approaches of the present disclosure.

### <9. Summary of Embodiments>

As explained above, an information processing device (information processing device 1) as one of the embodiments includes an optimization processing section (optimization processing section F1, F1A, F1B, F1C, or F1D) that updates and optimizes set parameters of a sensing device simulator (sensing device simulator SS) which estimates, on the basis of the parameters, sensing data obtained by a sensing device and that updates and optimizes set parameters of an analysis process executing section (analysis process executing section AP) which performs, on the basis of the parameters, an analysis process on the sensing data, on the basis of evaluation results of the analysis process performed by the analysis process executing section using, as an input, the sensing data estimated by the sensing device simulator.

By adopting an approach using the sensing device simulator as described above, in optimizing the designs of the sensing device and the analysis process, time and effort for manufacturing a sensor device in each occasion as in conventional techniques can be removed.

Accordingly, it is possible to comprehensively optimize the designs of the sensing device and the analysis process, and it is possible to attempt to reduce costs and time required for deriving optimum designs of the sensing device and the analysis process.

In addition, in the information processing device as one of the embodiments, the sensing device is an image capturing device, the analysis process is an image recognition process using an artificial intelligence model, and the optimization processing section uses, as an evaluation index in optimization, an image recognition reliability calculated in the image recognition process.

As a result, it is possible to optimize the parameters of each of the sensing device simulator and the analysis process executing section by the appropriate evaluation index that can cope with a case where the analysis process by the analysis process executing section is the image recognition process using the artificial intelligence model.

Further, in the information processing device as one of the embodiments, the analysis process is a process of sensing a particular thing, and the optimization processing section (optimization processing section F1A) uses, as an evaluation index in optimization, an amount of sensing error of the sensing process calculated as a reliability index of the sensing process (see FIG. 7).

As a result, it is possible to optimize the parameters of each of the sensing device simulator and the analysis process executing section by the appropriate evaluation index that can cope with a case where the analysis process by the analysis process executing section is the process of sensing the particular thing.

Moreover, in the information processing device as one of the embodiments, the optimization processing section (optimization processing section F1B) performs a process of calculating a device specification evaluation value which is a specification evaluation value of the sensing device, on the basis of the parameters of the sensing device simulator, and uses, as an evaluation index in optimization, information regarding the evaluation results of the analysis process and the device specification evaluation value (see FIG. 9).

As a result, the optimization is performed using, as evaluation indices, not only the information regarding the evaluation results of the analysis process by the analysis process executing section, but also, for example, the device specification evaluation value such as the electric power consumption, manufacturing cost, the housing size, or ease of designing of the sensing device.

Accordingly, design optimization of each of the sensing device and the analysis process can be performed such that desired device-specification conditions can be satisfied.

In addition, in the information processing device as one of the embodiments, the evaluation results of the analysis process are a reliability of the analysis process, and the optimization processing section calculates an evaluation value of the electric power consumption of the sensing device as the device specification evaluation value, and searches for the parameters that minimize the electric power consumption within such a range that a condition that the reliability of the analysis process is made equal to or greater than a certain value is satisfied.

As a result, design optimization of each of the sensing device and the analysis process can be performed such that the electric power consumption of the sensing device can be reduced as much as possible within such a range that the analysis process satisfies a predetermined performance condition.

Further, in the information processing device as one of the embodiments, the evaluation results of the analysis process are a reliability of the analysis process, and the optimization processing section calculates an evaluation value of the manufacturing cost of the sensing device as the device specification evaluation value, and searches for the parameters that minimize the manufacturing cost within such a range that a condition that the reliability of the analysis process is made equal to or greater than a certain value is satisfied.

As a result, design optimization of each of the sensing device and the analysis process can be performed such that the manufacturing cost of the sensing device can be reduced as much as possible within such a range that the analysis process satisfies a predetermined performance condition.

Moreover, in the information processing device as one of the embodiments, the sensing device is an image capturing device, the analysis process is an image analysis process on a sensing image captured by the image capturing device, and the optimization processing section searches for the parameters that maximize a focus blurring amount of the image capturing device within such a range that a condition that the image recognition reliability calculated in the image recognition process is made equal to or greater than a certain value is satisfied.

As a result, while the performance of the image analysis process is kept equal to or greater than certain performance, design optimization of each of the sensing device and the analysis process can be performed such that it is possible to attempt to protect privacy of a subject even in a case where a sensing image captured by the image capturing device is leaked.

In addition, in the information processing device as one of the embodiments, the sensing device is an image capturing device, the analysis process is an image analysis process on a sensing image captured by the image capturing device, the evaluation results of the analysis process are a reliability of the image analysis process of each type of subject captured in the sensing image input to the sensing device simulator, and the optimization processing section (optimization processing section F1C) searches for the parameters that make variations of the reliability of each type of subject equal to or smaller than a certain value on the basis of the reliability of each type of subject (see FIG. 11).

As a result, to cope with a case where the image analysis process is performed on different types of subjects, design optimization of each of the sensing device and the analysis process can be performed such that the robustness of the image analysis process against differences between the types of subjects is enhanced.

Further, in the information processing device as one of the embodiments, the optimization processing section searches for the parameters that satisfy a condition that the reliability of each type of subject is made equal to or greater than a predetermined value and an amount of error between the reliabilities of the types of subjects is made equal to or smaller than a certain value.

As a result, while it is ensured that the analysis performance of each type of subject is at or higher than certain performance, it is possible to attempt to enhance the robustness of the image analysis process against differences between the types of subjects.

Moreover, in the information processing device as one of the embodiments, the sensing device is an image capturing device, the analysis process is an image recognition process using an artificial intelligence model, and the optimization processing section (optimization processing section F1D) estimates a degree of contribution, to an image change in an area of interest in the image recognition process, of each of multiple parameters that can be set for the sensing device simulator, and performs the optimization by using, as an update-target parameter, a parameter selected on the basis of magnitudes of the degrees of contribution (see FIG. 13).

As a result, it becomes possible to efficiently reduce the number of update-target parameters in optimization, and it is possible to attempt to enhance the ease of convergence of the optimization process and shorten time required for the optimization process.

In addition, the information processing device as one of the embodiments includes a display control section (display control section F15) that generates display data representing changes of an optimization evaluation index which is an evaluation index used by the optimization processing section for the optimization and which is calculated for each parameter set tested in a course of the optimization, and performs a process of causing a display section to display the display data (see FIG. 16 to FIG. 18).

As a result, for example, it becomes possible to present, to a user, the display data representing changes, in the course of the parameter optimization process, of an optimization evaluation index such as the reliability of analysis process by the analysis process executing section.

Accordingly, it is possible to allow a user to grasp whether or not the parameter optimization process is proceeding well toward convergence.

Further, in the information processing device as one of the embodiments, the optimization is performed stepwise separately in multiple steps, and the display control section generates display data representing changes of the optimization evaluation index in each step, and causes the display section to display the display data.

As a result, it is possible to allow a user to grasp the optimization history of each step.

Moreover, in the information processing device as one of the embodiments, the display control section generates, as the display data, display data in which a graph representing the changes of the optimization evaluation index in each step is superimposed one on another, and causes the display section to display the display data.

As a result, it is possible to attempt to enhance the ease for the user to compare the optimization history of each step.

In addition, an information processing method as one of the embodiments is an information processing method including, by an information processing device, updating and optimizing set parameters of a sensing device simulator that estimates, on the basis of the parameters, sensing data obtained by a sensing device and updating and optimizing set parameters of an analysis process executing section that performs, on the basis of the parameters, an analysis process on the sensing data, on the basis of evaluation results of the analysis process performed by the analysis process executing section using, as an input, the sensing data estimated by the sensing device simulator.

Also with such an information processing method, effects and advantages similar to those achieved with the information processing device as one of the embodiments described above can be achieved.

In addition, a recording medium as one of the embodiments is a recording medium on which a program that can be read out by a computer device is recorded, the recording medium having recorded thereon the program that causes the computer device to realize a function to update and optimize set parameters of a sensing device simulator that estimates, on the basis of the parameters, sensing data obtained by a sensing device and update and optimize set parameters of an analysis process executing section that performs, on the basis of the parameters, an analysis process on the sensing data, on the basis of evaluation results of the analysis process performed by the analysis process executing section using, as an input, the sensing data estimated by the sensing device simulator.

With such a recording medium, the information processing device as one of the embodiments described above can be realized.

In addition, an information processing system (information processing system 100) as one of the embodiments includes an analysis process executing section (analysis process executing section AP) that performs an analysis process on sensing data obtained by a sensing device, on the basis of set parameters, a sensing device simulator (sensing device simulator SS) that estimates the sensing data on the basis of set parameters, and an optimization processing section (optimization processing section F1, F1A, F1B, F1C, or F1D) that updates and optimizes the parameters of the sensing device simulator and the parameters of the analysis process executing section on the basis of evaluation results of the analysis process performed by the analysis process executing section using, as an input, the sensing data estimated by the sensing device simulator.

With such an information processing system, it is possible to comprehensively optimize the designs of the sensing device and the analysis process, and it is possible to attempt to reduce costs and time required for deriving optimum designs of the sensing device and the analysis process.

Note that advantages described in the present specification are merely illustrated as examples and are not the sole examples, and there may be other advantages.

### <10. Present Technology>

The present technology can also adopt such configurations as described below.
(1) An information processing device including:
   an optimization processing section that updates and optimizes a set parameter of a sensing device simulator which estimates, on the basis of the parameter, sensing data obtained by a sensing device and that updates and optimizes a set parameter of an analysis process executing section which performs, on the basis of the parameter, an analysis process on the sensing data, on the basis of an evaluation result of the analysis process performed by the analysis process executing section using, as an input, the sensing data estimated by the sensing device simulator.
(2) The information processing device according to (1) above, in which
   the sensing device includes an image capturing device,
   the analysis process is an image recognition process using an artificial intelligence model, and
   the optimization processing section uses, as an evaluation index in the optimization, an image recognition reliability calculated in the image recognition process.
(3) The information processing device according to (1) above, in which
   the analysis process is a process of sensing a particular thing, and
   the optimization processing section uses, as an evaluation index in the optimization, an amount of sensing error of the sensing process calculated as a reliability index of the sensing process.
(4) The information processing device according to any one of (1) to (3) above, in which
   the optimization processing section
   performs a process of calculating a device specification evaluation value which is a specification evaluation value of the sensing device, on the basis of the parameter of the sensing device simulator, and
   uses, as an evaluation index in the optimization, information regarding the evaluation result of the analysis process and the device specification evaluation value.
(5) The information processing device according to (4) above, in which
   the evaluation result of the analysis process is a reliability of the analysis process, and
   the optimization processing section
      calculates an evaluation value of electric power consumption of the sensing device as the device specification evaluation value, and
      searches for the parameters that minimize the electric power consumption within such a range that a condition that the reliability of the analysis process is made equal to or greater than a certain value is satisfied.
(6) The information processing device according to (4) or (5) above, in which
   the evaluation result of the analysis process is a reliability of the analysis process, and
   the optimization processing section
      calculates an evaluation value of a manufacturing cost of the sensing device as the device specification evaluation value, and
      searches for the parameters that minimize the manufacturing cost within such a range that a condition that the reliability of the analysis process is made equal to or greater than a certain value is satisfied.
(7) The information processing device according to any one of (1) to (6) above, in which
   the sensing device includes an image capturing device,
   the analysis process is an image analysis process on a sensing image captured by the image capturing device, and
   the optimization processing section searches for the parameters that maximize a focus blurring amount of the image capturing device within such a range that a condition that an image recognition reliability calculated in the image recognition process is made equal to or greater than a certain value is satisfied.
(8) The information processing device according to any one of (1) to (7) above, in which
   the sensing device includes an image capturing device,
   the analysis process is an image analysis process on a sensing image captured by the image capturing device,
   the evaluation result of the analysis process is a reliability of the image analysis process of each type of subject captured in the sensing image input to the sensing device simulator, and
   the optimization processing section searches for the parameters that make variations of the reliability of each type of subject equal to or smaller than a certain value on the basis of the reliability of each type of subject.
(9) The information processing device according to (8) above, in which
   the optimization processing section searches for the parameters that satisfy a condition that the reliability of each type of subject is made equal to or greater than a predetermined value and an amount of error between the reliabilities of the types of subjects is made equal to or smaller than a certain value.
(10) The information processing device according to any one of (1) to (9) above, in which
   the sensing device includes an image capturing device,
   the analysis process is an image recognition process using an artificial intelligence model, and
   the optimization processing section estimates a degree of contribution, to an image change in an area of interest in the image recognition process, of each of multiple parameters that are allowed to be set for the sensing device simulator, and performs the optimization by using, as an update-target parameter, a parameter selected on the basis of magnitudes of the degrees of contribution.
(11) The information processing device according to any one of (1) to (10) above, including:
   a display control section that generates display data representing changes of an optimization evaluation index which is an evaluation index used by the optimization processing section for the optimization and which is calculated for each parameter set tested in a course of the optimization, and performs a process of causing a display section to display the display data.
(12) The information processing device according to (11) above, in which
   the optimization is performed stepwise separately in multiple steps, and
   the display control section generates display data representing changes of the optimization evaluation index in each step, and causes the display section to display the display data.
(13) The information processing device according to (12) above, in which
   the display control section generates, as the display data, display data in which a graph representing the changes of the optimization evaluation index in each step is superimposed one on another, and causes the display section to display the display data.
(14) An information processing method including:
   by an information processing device, updating and optimizing a set parameter of a sensing device simulator that estimates, on the basis of the parameter, sensing data obtained by a sensing device and updating and optimizing a set parameter of an analysis process executing section that performs, on the basis of the parameter, an analysis process on the sensing data, on the basis of an evaluation result of the analysis process performed by the analysis process executing section using, as an input, the sensing data estimated by the sensing device simulator.
(15) A recording medium on which a program that is able to be read out by a computer device is recorded, the recording medium having recorded thereon the program that causes the computer device to realize:
   a function to update and optimize a set parameter of a sensing device simulator that estimates, on the basis of the parameter, sensing data obtained by a sensing device and update and optimize a set parameter of an analysis process executing section that performs, on the basis of the parameter, an analysis process on the sensing data, on the basis of an evaluation result of the analysis process performed by the analysis process executing section using, as an input, the sensing data estimated by the sensing device simulator.
(16) An information processing system including:
   an analysis process executing section that performs an analysis process on sensing data obtained by a sensing device, on the basis of a set parameter;
   a sensing device simulator that estimates the sensing data on the basis of a set parameter; and
   an optimization processing section that updates and optimizes the parameter of the sensing device simulator and the parameter of the analysis process executing section on the basis of an evaluation result of the analysis process performed by the analysis process executing section using, as an input, the sensing data estimated by the sensing device simulator.

### [Reference Signs List]

100: Optimization system
1, 2, 3: Information processing device
4: Database
SS: Sensing device simulator
AP: Analysis process executing section
F1, F1A, F1B, F1C, F1D: Optimization processing section
4a: Subject information group
4b: Sensing parameter group
4c: Analysis process parameter group
11: CPU
11a: Use preparation processing section
11b: Use start time processing section
11c: Use control section
12: ROM
13: RAM
14: Non-volatile memory section
15: Input/output interface
16: Input section
17: Display section
18: Sound output section
19: Storage section
20: Communicating section
21: Drive
22: Removable storage medium
23: Bus
S1: Lens section
S2: Color filter
S3: I/V converting section
S4: Electric-charge/voltage converting section
S5: Fixed noise adding section
S6: Random noise adding section
S7: Analog gain section
S8: A/D converting section
F5: Amount-of-sensing-error computing section
F10: Specification evaluating section
F11: Image change amount computing section
F15: Display control section

## Claims

1. An information processing device comprising:
an optimization processing section that updates and optimizes a set parameter of a sensing device simulator which estimates, on a basis of the parameter, sensing data obtained by a sensing device and that updates and optimizes a set parameter of an analysis process executing section which performs, on a basis of the parameter, an analysis process on the sensing data, on a basis of an evaluation result of the analysis process performed by the analysis process executing section using, as an input, the sensing data estimated by the sensing device simulator.

2. The information processing device according to claim 1, wherein
the sensing device includes an image capturing device,
the analysis process is an image recognition process using an artificial intelligence model, and
the optimization processing section uses, as an evaluation index in the optimization, an image recognition reliability calculated in the image recognition process.

3. The information processing device according to claim 1, wherein
the analysis process is a process of sensing a particular thing, and
the optimization processing section uses, as an evaluation index in the optimization, an amount of sensing error of the sensing process calculated as a reliability index of the sensing process.

4. The information processing device according to claim 1, wherein
the optimization processing section
performs a process of calculating a device specification evaluation value which is a specification evaluation value of the sensing device, on a basis of the parameter of the sensing device simulator, and
uses, as an evaluation index in the optimization, information regarding the evaluation result of the analysis process and the device specification evaluation value.

5. The information processing device according to claim 4, wherein
the evaluation result of the analysis process is a reliability of the analysis process, and
the optimization processing section
calculates an evaluation value of electric power consumption of the sensing device as the device specification evaluation value, and
searches for the parameters that minimize the electric power consumption within such a range that a condition that the reliability of the analysis process is made equal to or greater than a certain value is satisfied.

6. The information processing device according to claim 4, wherein
the evaluation result of the analysis process is a reliability of the analysis process, and
the optimization processing section
calculates an evaluation value of a manufacturing cost of the sensing device as the device specification evaluation value, and
searches for the parameters that minimize the manufacturing cost within such a range that a condition that the reliability of the analysis process is made equal to or greater than a certain value is satisfied.

7. The information processing device according to claim 1, wherein
the sensing device includes an image capturing device,
the analysis process is an image analysis process on a sensing image captured by the image capturing device, and
the optimization processing section searches for the parameters that maximize a focus blurring amount of the image capturing device within such a range that a condition that an image recognition reliability calculated in the image recognition process is made equal to or greater than a certain value is satisfied.

8. The information processing device according to claim 1, wherein
the sensing device includes an image capturing device,
the analysis process is an image analysis process on a sensing image captured by the image capturing device,
the evaluation result of the analysis process is a reliability of the image analysis process of each type of subject captured in the sensing image input to the sensing device simulator, and
the optimization processing section searches for the parameters that make variations of the reliability of each type of subject equal to or smaller than a certain value on a basis of the reliability of each type of subject.

9. The information processing device according to claim 8, wherein
the optimization processing section searches for the parameters that satisfy a condition that the reliability of each type of subject is made equal to or greater than a predetermined value and an amount of error between the reliabilities of the types of subjects is made equal to or smaller than a certain value.

10. The information processing device according to claim 1, wherein
the sensing device includes an image capturing device,
the analysis process is an image recognition process using an artificial intelligence model, and
the optimization processing section estimates a degree of contribution, to an image change in an area of interest in the image recognition process, of each of multiple parameters that are allowed to be set for the sensing device simulator, and performs the optimization by using, as an update-target parameter, a parameter selected on a basis of magnitudes of the degrees of contribution.

11. The information processing device according to claim 1, comprising:
a display control section that generates display data representing changes of an optimization evaluation index which is an evaluation index used by the optimization processing section for the optimization and which is calculated for each parameter set tested in a course of the optimization, and performs a process of causing a display section to display the display data.

12. The information processing device according to claim 11, wherein
the optimization is performed stepwise separately in multiple steps, and
the display control section generates display data representing changes of the optimization evaluation index in each step, and causes the display section to display the display data.

13. The information processing device according to claim 12, wherein
the display control section generates, as the display data, display data in which a graph representing the changes of the optimization evaluation index in each step is superimposed one on another, and causes the display section to display the display data.

14. An information processing method comprising:
by an information processing device, updating and optimizing a set parameter of a sensing device simulator that estimates, on a basis of the parameter, sensing data obtained by a sensing device and updating and optimizing a set parameter of an analysis process executing section that performs, on a basis of the parameter, an analysis process on the sensing data, on a basis of an evaluation result of the analysis process performed by the analysis process executing section using, as an input, the sensing data estimated by the sensing device simulator.

15. A recording medium on which a program that is able to be read out by a computer device is recorded, the recording medium having recorded thereon the program that causes the computer device to realize:
a function to update and optimize a set parameter of a sensing device simulator that estimates, on a basis of the parameter, sensing data obtained by a sensing device and update and optimize a set parameter of an analysis process executing section that performs, on a basis of the parameter, an analysis process on the sensing data, on a basis of an evaluation result of the analysis process performed by the analysis process executing section using, as an input, the sensing data estimated by the sensing device simulator.

16. An information processing system comprising:
an analysis process executing section that performs an analysis process on sensing data obtained by a sensing device, on a basis of a set parameter;
a sensing device simulator that estimates the sensing data on a basis of a set parameter; and
an optimization processing section that updates and optimizes the parameter of the sensing device simulator and the parameter of the analysis process executing section on a basis of an evaluation result of the analysis process performed by the analysis process executing section using, as an input, the sensing data estimated by the sensing device simulator.
